(19) Europäisches Patentamt
European Patent Office
Office européen des brevets

(11) **EP 2 453 486 A2**

(12) **EUROPEAN PATENT APPLICATION**
published in accordance with Art. 153(4) EPC

(43) Date of publication:
**16.05.2012 Bulletin 2012/20**

(51) Int Cl.:
***H01L 33/00*** (2010.01)

(21) Application number: **09793861.7**

(86) International application number:
**PCT/CN2009/072729**

(22) Date of filing: **10.07.2009**

(87) International publication number:
**WO 2010/003386 (14.01.2010 Gazette 2010/02)**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(71) Applicant: **Industrial Technology Research Institute**
**Hsinchu 31040 (TW)**

(72) Inventors:
• **XUAN, Rong**
  **Taipei County 234**
  **Taiwan (CN)**
• **LI, Chao-Wei**
  **Taipei City 112**
  **Taiwan (CN)**

• **HU, Hung-Lieh**
  **Hsinchu City 300**
  **Taiwan (CN)**
• **CHU, Mu-Tao**
  **Hsinchu City 300**
  **Taiwan (CN)**
• **HSU, Chih-Hao**
  **Hsinchu City 300**
  **Taiwan (CN)**
• **TSAY, Jenq-Dar**
  **Kaohsiung**
  **Taiwan (CN)**

(74) Representative: **Becker Kurig Straus**
**Bavariastrasse 7**
**80336 München (DE)**

(54) **LIGHT-EMITTING DEVICE AND PACKAGING STRUCTURE THEREOF**

(57)     A packaging structure for a light-emitting device includes a carrier, at least one light-emitting device and a magnetic element. The magnetic element aids in enhancing overall luminous output efficiency.

FIG. 8

EP 2 453 486 A2

**Description**

Technical Field

The disclosure relates to a light-emitting device and a package structure of the light-emitting device.

Background

Different to a fluorescent light or an incandescent light that produces light through heating, a semiconductor light-emitting device package structure such as a light-emitting diode (LED) produces light based on a characteristic of the semiconductor, and the light emitted by such light-emitting device package structure is referred to as cold luminescence. Such light-emitting device package structure has advantages of long service life, light weight and low power consumption, etc., and is adapted to be used in various domains, such as optical displays, traffic signal lamps, data storage devices, communication devices, lighting devices and medical equipment. Therefore, it is an important issue to increase light-emitting efficiency of the light-emitting device package structure.

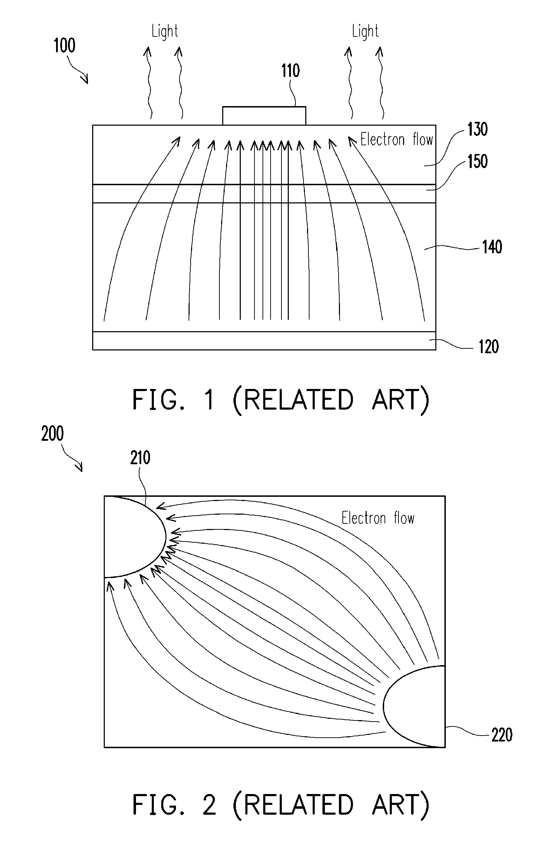

FIG. 1 is a cross-sectional view of a light-emitting device in a conventional light-emitting device package structure. Referring to FIG. 1, the light-emitting device 100 is a vertical LED device, which includes electrodes 110 and 120, a first doped layer 130, a second doped layer 140 and a semiconductor light-emitting layer 150 between the first doped layer 130 and the second doped layer 140, where the electrode 110 is located on the first doped layer 130, and the electrode 120 is located on the second doped layer 140. As a distance between the electrodes 110 and 120 increases, a distribution of a current density is gradually decreased. As shown in FIG. 1, denser lines represent a higher current density, and a region with the most lines is located between the electrodes 110 and 120. However, since the region with the highest light-emitting efficiency is only concentrated between the electrodes 110 and 120, an overall light-emitting efficiency of the light-emitting device 100 is relatively low.

FIG. 2 is a top view of a light-emitting device in a conventional light-emitting device package structure. Referring to FIG. 2, a light-emitting device 200 is a horizontal LED device, which includes electrodes 210 and 220. Since a current is transmitted through a path with a lowest resistance, the current density is mainly concentrated at a central path between the electrodes 210 and 220, so that overall light-emitting efficiency of the light-emitting device 200 is relatively low.

SUMMARY

The invention is directed to a light-emitting device and a package structure of the light-emitting device, based on magnetic element packaging or by adding a magnetic element to the light-emitting device, the light-emitting device has better light-emitting efficiency.

The disclosure provides a light-emitting device including a light-emitting structure and a magnetic material structure. The light-emitting structure includes a P-type semiconductor layer, an N-type semiconductor layer having a resistivity $\rho_n$, a thickness $t_n$ and a carrier mobility $\mu_n$, an active layer disposed between the P-type semiconductor layer and the N-type semiconductor layer, and a transparent conductive layer disposed on the P-type semiconductor layer and having a resistivity $\rho_t$, a thickness $t_t$ and a carrier mobility $\mu_t$. The magnetic material structure is coupled to the light-emitting structure to generate a magnetic field B in the light-emitting structure. A first magnetoresistance parameter

$$\frac{\rho_t}{t_t}(1+\mu_t^2 B^2)$$ of the transparent conductive layer is substantially equal to a second magnetoresistance parameter

$$\frac{\rho_n}{t_n}(1+\mu_n^2 B^2)$$ of the N-type semiconductor layer.

The disclosure provides a light-emitting device including a light-emitting structure and a magnetic material structure. The light-emitting structure has a top surface and includes a first type semiconductor layer, a second type semiconductor layer, an active layer disposed between the first type semiconductor layer and the second type semiconductor layer, a transparent conductive layer disposed on the first type semiconductor layer, a first electrode structure disposed on the transparent conductive layer and coupled to the first type semiconductor layer and including a first connection pad and a first electrode, and a second electrode structure coupled to the second type semiconductor layer. The magnetic material structure is coupled to the light-emitting structure to generate a magnetic field B in the light-emitting structure. The first electrode structure and the second electrode structure are located at a same side of the light-emitting structure.

The disclosure provides a light-emitting device including a light-emitting structure and a magnetic material structure. The light-emitting structure has a top surface and includes a first type semiconductor layer, a second type semiconductor layer, an active layer disposed between the first type semiconductor layer and the second type semiconductor layer, a transparent conductive layer disposed on the first type semiconductor layer, a first electrode structure coupled to the first type semiconductor layer and including a first electrode and a first connection pad, where the first electrode has a first set of parallel outlines. The light-emitting structure further includes a second electrode structure coupled to the second type semiconductor layer and having a second electrode and a second connection pad, where the second electrode has a second set of parallel outlines. The magnetic material structure is coupled to the light-emitting structure to generate a magnetic field B in the light-emitting structure. The first electrode and the second electrode are disposed in interlace, and the first set of parallel outlines and the second set of parallel outlines are disposed in parallel.

The disclosure provides a light-emitting device including a light-emitting structure and at least one magnetic field generator. The light-emitting structure includes a first type semiconductor layer, a second type semiconductor layer, an active layer disposed between the first type semiconductor layer and the second type semiconductor layer, a transparent conductive layer covering the second type semiconductor layer, where the first type semiconductor layer, the second type semiconductor layer or the transparent conductive layer includes a weak magnetic material. The magnetic field generator is located to at least one side of the light-emitting device to generate a magnetic field B.

The disclosure provides a nitride semiconductor template including a submount, a bonding layer disposed on the submount, and a nitride semiconductor layer disposed on the bonding layer, where the nitride semiconductor layer includes a weak magnetic material.

The disclosure provides a light-emitting device package structure including a carrier, at least one light-emitting device disposed on the carrier, and a first magnetic element located independent to the light-emitting device for providing a magnetic field to the light-emitting device.

In order to make the aforementioned and other features and advantages of the disclosure comprehensible, several exemplary embodiments accompanied with figures are described in detail below.

BRIEF DESCRIPTION OF THE DRAWINGS

The accompanying drawings are included to provide a further understanding of the disclosure, and are incorporated in and constitute a part of this specification. The drawings illustrate embodiments of the disclosure and, together with the description, serve to explain the principles of the disclosure.

FIG. 1 is a cross-sectional view of a light-emitting device in a conventional light-emitting device package structure.

FIG. 2 is a top view of a light-emitting device in a conventional light-emitting device package structure.

FIG. 3 is a cross-sectional view of a light-emitting device in a light-emitting device package structure according to an embodiment of the disclosure.

FIG. 4 is a top view of a light-emitting device in a light-emitting device package structure according to an embodiment of the disclosure.

FIG. 5 is a curve diagram illustrating a relationship between a magnetic field intensity exerted on a light-emitting device and light-emitting efficiency of the light-emitting device according to an embodiment of the disclosure.

FIG. 6 and FIG. 7 are cross-sectional views of light-emitting devices according to embodiments of the disclosure.

FIG. 8 and FIG. 9 are cross-sectional views of light-emitting devices according to embodiments of the disclosure.

FIG. 10 is distribution curve of a thickness of a transparent conductive layer (TCL) in a conventional light-emitting device and current distribution evenness in case that a magnetic field is not applied.

FIG. 11 and FIG. 12 are cross-sectional views of light-emitting devices according to embodiments of the disclosure.

FIG. 13 is a cross-sectional view of a light-emitting device according to an embodiment of the disclosure.

FIG. 14A is a cross-sectional view of a light-emitting device package structure according to an embodiment of the disclosure.

FIG. 14B is a top view of FIG. 14A, where FIG. 14A is a cross-sectional view of FIG. 14B along a line I-I'.

FIG. 14C-FIG. 14M illustrate a plurality of variations of the light-emitting device package structure of FIG. 14A.

FIG. 15A is a cross-sectional view of a light-emitting device package structure according to an embodiment of the disclosure.

FIG. 15B is a variation of the light-emitting device package structure of FIG. 15A.

FIG. 15C is a top view of the light-emitting device package structure of FIG. 15B, and FIG. 15B is a cross-sectional view of FIG. 15C along a line II-II'.

FIG. 16A is a cross-sectional view of a light-emitting device package structure according to an embodiment of the disclosure.

FIG. 16B-16D are variations of the light-emitting device package structure of FIG. 16A.

FIG. 17A, FIG. 17B and FIG. 17C are respectively three variations of FIGs. 16A-16C.

FIG. 17D and FIG. 17E are schematic diagrams of light-emitting device package structures according to other embodiments of the disclosure.

FIG. 18A is a cross-sectional view of a light-emitting device package structure according to an embodiment of the disclosure.

FIGs. 18B-18E are four variations of the light-emitting device package structure of FIG. 18A.

FIG. 19A is a cross-sectional view of a light-emitting device package structure according to an embodiment of the disclosure.

FIG. 19B and FIG. 19C are two variations of the light-emitting device package structure of FIG. 19A.

FIGs. 20A-20C are three variations of FIGs. 19A-19C.

FIG. 20D is a schematic diagram of a light-emitting device package structure according to another embodiment of the disclosure.

FIG. 21 is a cross-sectional view of a light-emitting device package structure according to an embodiment of the disclosure.

FIG. 22 to FIG. 31 are schematic diagrams of a horizontal electrode type magnetic light-emitting apparatus according to an embodiment of the disclosure.

FIG. 32 is a schematic diagram of a vertical electrode type magnetic light-emitting device according to an embodiment of the disclosure.

FIG. 33 is a schematic diagram of a flip-chip type magnetic light-emitting device according to an embodiment of the disclosure.

FIG. 34A to FIG. 34B are schematic diagrams illustrating a fabrication flow of a magnetic light-emitting device according to an embodiment of the disclosure.

FIG. 35A to FIG. 35B are schematic diagrams illustrating a fabrication flow of a magnetic light-emitting device according to an embodiment of the disclosure.

FIG. 36A to FIG. 36C are schematic diagrams illustrating a fabrication flow of a magnetic light-emitting device according to an embodiment of the disclosure.

FIG. 37A to FIG. 37C are schematic diagrams illustrating a fabrication flow of a magnetic light-emitting device according to an embodiment of the disclosure.

FIG. 38A to FIG. 38G are schematic diagrams illustrating a fabrication flow of a magnetic light-emitting device according to an embodiment of the disclosure.

FIG. 39 is a cross-sectional view of a light-emitting device according to an embodiment of the disclosure.

FIG. 40A to FIG. 40C are top views of a light-emitting device according to an embodiment of the disclosure.

FIG. 41A to FIG. 41C are top views of a light-emitting device according to another embodiment of the disclosure.

FIG. 42A to FIG. 42C are top views of a light-emitting device according to another embodiment of the disclosure.

FIG. 43A to FIG. 43C are top views of a light-emitting device according to another embodiment of the disclosure.

DETAILED DESCRIPTION OF DISCLOSED EMBODIMENTS

A component perpendicular to a current flow may produce a Lorenz's force to the current, which satisfies an equation $F=q*v*B$, and the Lorenz's force may cause a transverse shift of a current path. In the disclosure, a current path in a light-emitting device can be changed according to the effect of the Lorenz's force, so as to improve evenness of current distribution in the light-emitting device, and accordingly improve light-emitting evenness and overall light-emitting efficiency of a light-emitting device package structure. The light-emitting device is, for example, a light-emitting diode (LED) device or a laser LED device.

In detail, a magnetic element is added to the light-emitting device package structure to provide a magnetic field to the light-emitting device in the light-emitting device package structure. Influences of the magnetic field on the current path in the light-emitting device are described below.

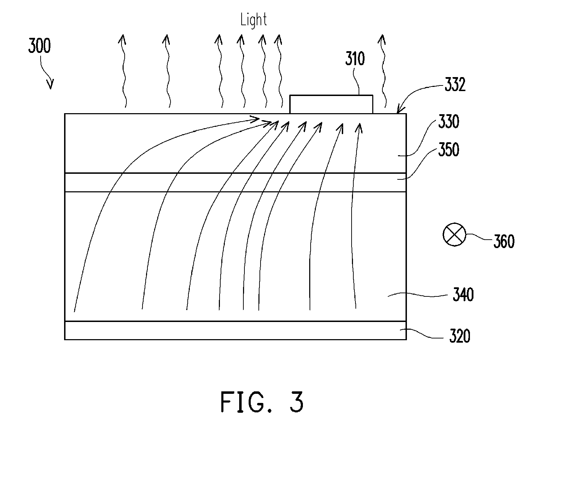

FIG. 3 is a cross-sectional view of a light-emitting device in a light-emitting device package structure according to an embodiment of the disclosure. Referring to FIG. 3, the light-emitting device 300 is, for example, a vertical LED device, which includes two electrodes 310 and 320, a first doped layer 330, a second doped layer 340 and a light emitting layer 350, where the light-emitting layer 350 is located between the first doped layer 330 and the second doped layer 340, and the electrodes 310 and 320 are respectively disposed on the first doped layer 330 and the second doped layer 340. The first doped layer 330 and the second doped layer 340 can be a P-type doped layer and an N-type doped layer.

The light-emitting device 300 is located in a magnetic field 360, and the magnetic field 360 is generated by a magnetic element (not shown) in the light-emitting device package structure, and a direction of the magnetic field 360 points to a paper surface. The Lorenz's force generated by magnetic field induction drives electrons, so that the current is shifted leftwards. A main distribution (represented by electron flow lines) of current density can be shifted from a region between the electrodes 310 and 320 to a region below a light-out plane 332, which represents that the magnetic field 360 can effectively improve evenness of the current density and substantially improve overall light-emitting efficiency of the light-emitting device 300. The light-out plane 332 mentioned in the context is defined as a surface on the first doped layer 330 that is not covered by the electrode 310. It should be noticed that as long as a component of the magnetic field is perpendicular to a flowing direction of the internal current of the light-emitting device 300, the Lorenz's force is induced to shift the current to improve the light-emitting efficiency.

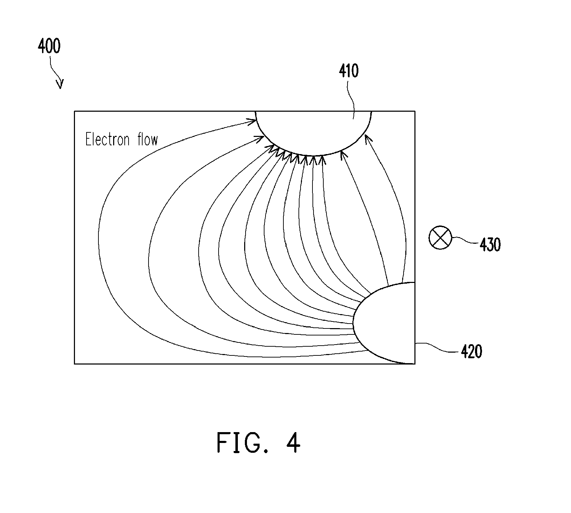

In another embodiment, FIG. 4 is a top view of a light-emitting device in a light-emitting device package structure according to an embodiment of the disclosure. Referring to FIG. 4, the light-emitting device 400 is, for example, a horizontal LED device. Similar to the aforementioned embodiment, the Lorenz's force induced by a magnetic field 430 drives the electrons, so that the current between electrodes 410 and 420 of the light-emitting device 400 is shifted leftwards. In this way, the current path is expanded to a larger region (a region at the left part), and the current distribution can be more even.

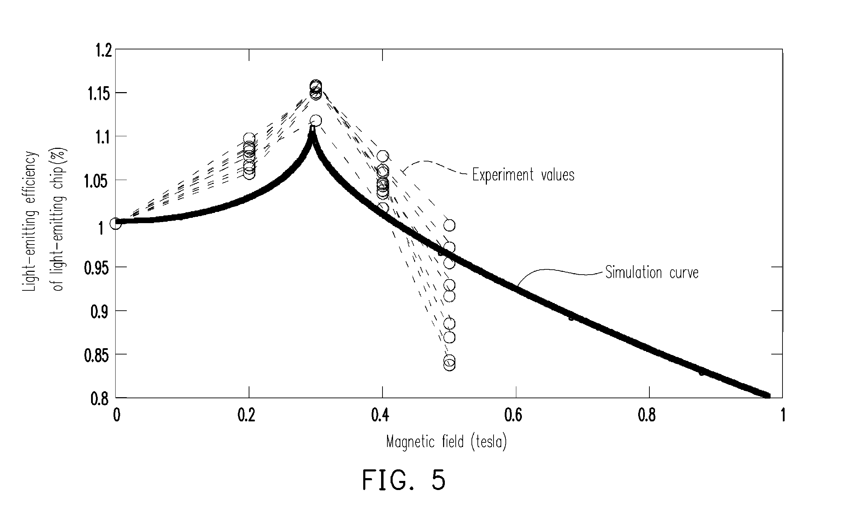

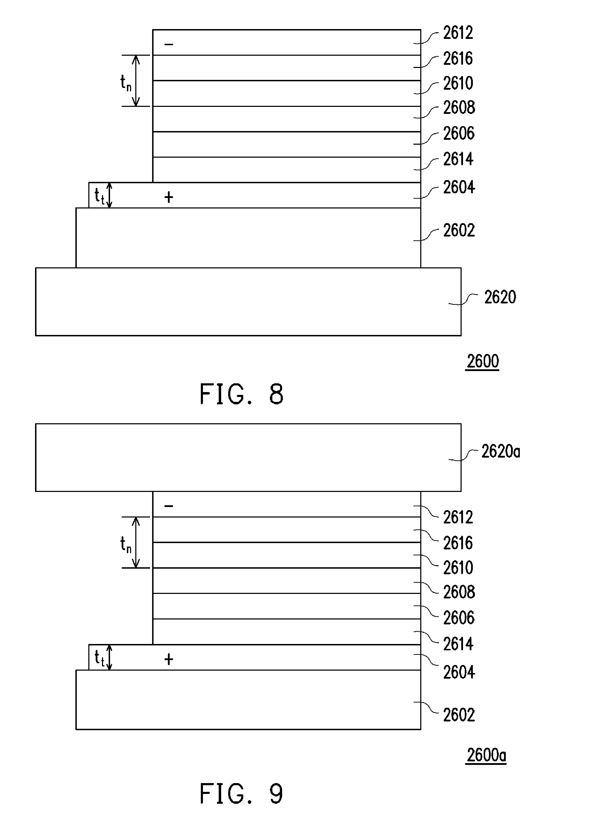

FIG. 5 is a curve diagram illustrating a relationship between a magnetic field intensity exerted on the light-emitting device and light-emitting efficiency of the light-emitting device according to an embodiment of the disclosure. In FIG. 5, 9 sets of experimental values (dot lines) of the light-emitting efficiency of the light-emitting device in the magnetic field and a simulation curve (a solid line) are illustrated,

According to FIG. 5, it is known that by applying the magnetic field on the light-emitting device, the light-emitting efficiency of the light-emitting device can be effectively improved, and when the magnetic field is a specific value, the light-emitting efficiency of the light-emitting device may reach a maximum value.

Related principle of diffusion capability of the drifted current is deduced below to describe how the current density is influenced by the external magnetic field.

In physics, the Lorenz's force refers to a force exerted on charged particles in an electromagnetic field. The particles sustain a force formed by an electric field $qE$ and a magnetic field $q \cdot \vec{v} \times \vec{B}$ A force $F$ induced by the magnetic field $B$ can be calculated according to a following Lorenz's force equation.

By applying the external magnetic field on the light-emitting device, not only a current path is changed, but also evenness of carrier density in the semiconductor is changed. Therefore, even if an amount of an input current is maintained unchanged, the light-emitting device still has higher photoelectric conversion efficiency.

It should be noticed that an intensity of the external magnetic field exerted on the light-emitting device is greater than 0.01 gauss, which can be a fixed value, a time-varying value or a gradient-varying value, though the disclosure is not limited thereto. Moreover, an angle formed between a magnetic field direction and a light-emitting direction is 0 to 360 degrees. In addition, the magnetic field is provided by a magnet, a magnetic thin film, an electromagnet or any other magnetic materials, and a number of the magnetic sources can be more than one.

According to the above descriptions, in an actual application, the light-emitting device can be combined with the magnetic material through various manners, for example, through epoxy, metal bonding, wafer bonding, epitaxy embedding and coating. Moreover, the magnetic material can be coupled to the light-emitting device to be fabricated as a substrate, a submount, an electromagnet, a slug, a retainer or a magnetic heat sink, or fabricated as a magnetic film, a magnet bulk or a magnetic ring for providing the magnetic field to the light-emitting device. The light-emitting device can be a vertical or a horizontal LED device or laser LED device.

Based on a structure design of the light-emitting device, the current density can be even and the two electrode layers may have a good impedance matching there between to improve the light-emitting efficiency. A plurality of embodiments of the structure design of the light-emitting device is described below.

The light-emitting device can emit light by driving a current to pass through an active layer of the LED. However, if the current density is not evenly distributed to the whole light-emitting region, light evenness is decreased. Further, in a conventional design, a non-transparent top electrode is generally located at a center of the light-emitting region. In this way, a current density below the top electrode is greater than that of the other regions, which may produce more light. However, since the top electrode is non-transparent, the light emitted below the top electrode is blocked by the top electrode. The top electrode of the conventional LED blocks the central region that has a highest light-emitting intensity, so that a light output is decreased.

How to improve the light output efficiency of the LED is an important issue to be developed in the related technical domain. The disclosure provides a plurality of structure designs below.

Under an effect of the Lorenz's force, when the current flows through a wire and the external magnetic field is transversely applied, a path of the current (for example, an electron flow) is transversely shifted due to a magnetic Lorenz's force F=q*v*B, which may resolve a current crowding phenomenon. In this way, the current distribution can be more even to improve the light-emitting efficiency.

Moreover, when a quantum effect is considered, the magnetic force applied to the light-emitting device (for example, an LED) can also improve a light conversion efficiency of the light-emitting device. A basic mechanism thereof is that usage of the magnetic field can increase exciting binding energy of a bandgap in material of an active region, so as to enhance a probability of carrier recombination. In detail, an exiting binding energy between a conduction band and a valence band can be closer to the valence band with assistance of the magnetic field, by which internal quantum efficiency (IQE) of the material of the light-emitting device can be effectively enhanced. Generally, regarding the material with the exciting binding energy higher than a thermal voltage (for example, higher than about 25.8meV) in a room temperature, improvement of the IQE is more obvious. A light-emitting structure of the light-emitting device includes a semiconductor material having the exiting binding energy. In an embodiment, the light-emitting structure of the light-emitting device may include an inorganic material having the exiting binding energy higher than 25.8meV. The inorganic material can be a nitride-based material, for example, GaN. The other inorganic materials having the exiting binding energy higher than 25.8meV (for example, Si, CdS, BaO, KI, KC1, KBr, RbCl, LiF and AgCl) can also be applied in the light-emitting structure. In an embodiment, the light-emitting structure of the light-emitting device may include an organic material having the exiting binding energy higher than 25.8meV, for example, a phosphorescent material, or a fluorescent material, etc. For example, the phosphorescent material can be red, green, blue or a dendrimer, and the fluorescent material can be red, green, blue, yellow or white.

The exiting binding energy of the semiconductor material is increased as a magnitude of the applied magnetic field increases. In other words, the magnetic field applied on the light-emitting device can additionally increase the exciting binding energy, the IQE and the carrier recombination, so as to effectively improve the light-emitting efficiency.

In case that the external magnetic field is applied on the light-emitting device, not only evenness of the semiconductor carrier density is changed, but also the light-emitting efficiency is improved. Therefore, regarding a photoelectric conversion, although the amount of the input current is maintained unchanged, the light-emitting device may have high light-emitting efficiency.

In the disclosure, an intensity of the external magnetic field applied on the light-emitting device can be greater than 0.01 gauss. Moreover, the magnetic field can be provided by a magnet, a magnetic thin film, an electromagnet or any other magnetic materials, and the number of the magnetic fields is not limited by the disclosure. Moreover, the magnetic material can be connected to the light-emitting device by means of a magnetic film or a magnetic bulk, which is determined by a thickness thereof. It should be noticed that a direction of the magnetic field can be suitably arranged, for example, vertically or horizontally arranged or arranged in any direction relative to the light-emitting device. The magnetic material can be a ferromagnetic material or a ceramic material. The light-emitting device can be an inorganic LED or an organic LED (OLED), and the light-emitting device can also be a vertical type, a horizontal type, a thin-film type or a flip chip type.

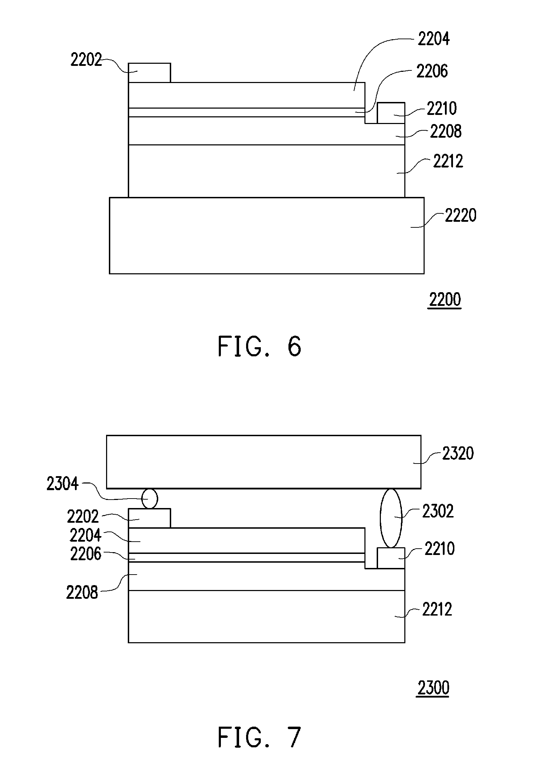

Regarding a standard LED having a horizontal structure, FIG. 6 is a cross-sectional view of a light-emitting device according to an embodiment of the disclosure. Referring to FIG. 6, the light-emitting device 2200 is a horizontal LED, which includes a light-emitting structure coupled to a magnetic material. In an embodiment, the light-emitting structure is disposed on a magnetic submount 220 through epoxy, metal bonding, wafer bonding, epitaxy embedding or coating. The magnetic submount 2220, for example, has a ferromagnetic layer magnetized along a desired direction.

The light-emitting structure includes a first electrode 2202, a first doped layer 2204, an active layer 2206, a second doped layer 2208, a second electrode 2210 and a substrate 2212. The substrate 2212 is installed on the magnetic submount 2220. The first doped layer 2204 (for example, a P-type doped layer), the active layer 2206 and the second doped layer 2208 (for example, an N-type doped layer) commonly form a light-emitting stacking layer disposed on the substrate 2212. The first electrode 2202 is disposed on the first doped layer 2204 and is electrically connected to the first doped layer 2204. The second electrode 2210 is disposed at a side the same to that of the first electrode 2202 and is electrically connected to the second doped layer 2208. Therefore, the horizontal LED structure is formed. The active layer 2206 is disposed between the first doped layer 2204 and the second doped layer 2208, and can generate light when a current flowing there through.

By applying the magnetic field generated by the magnetic submount 2220 on the light-emitting structure, the exciting binding energy of the semiconductor material in the light-emitting structure is increased to improve the overall light-emitting efficiency of the light-emitting device 2200.

FIG. 7 is a cross-sectional view of a light-emitting device according to an embodiment of the disclosure. The same reference numbers in FIG. 6 and FIG. 7 denote the same or like components, and descriptions of the same technical contents are omitted.

Referring to FIG. 7, a structure of the light-emitting device 2300 is similar to a structure of the light-emitting device 2200 of FIG. 6, and a difference there between lies in deployment of the magnetic material. In an embodiment, to implement the magnetic source, a package structure (for example, a flip chip bond) is used to couple the magnetic material and the light-emitting structure. The first electrode 2202 and the second electrode 2210 of the light-emitting structure can be installed on a magnetic submount 2320. In an embodiment, bonding structures 2302 and 2304 can be used to package the light-emitting structure to the magnetic submount 2320. The bonding structures 2302 and 2304 are, for example, bonding bumps. In another embodiment, the light-emitting structure can be directly bonded to the magnetic submount 2320 without using the bonding structures. Namely, the first electrode 2202 and the second electrode 2210 can be directly mounted to the surface of the magnetic submount. As a result, the magnetic submount 2320 can generate a magnetic field influencing the light-emitting device 2300, and the exciting binding energy of the semiconductor material in the light-emitting structure is accordingly increased to improve the light-emitting efficiency of the light-emitting device 2300.

FIG. 8 and FIG. 9 are cross-sectional views of light-emitting devices according to embodiments of the disclosure. The same reference numbers in FIG. 8 and FIG. 9 denote the same or like components, and descriptions of the same technical contents are omitted.

Referring to FIG. 8, the light-emitting device 2600 includes a light-emitting structure coupled to a magnetic layer 2620. In an embodiment, the light-emitting structure is disposed on the magnetic layer 2620 through epoxy, metal bonding, wafer bonding, epitaxy embedding or coating.

The light-emitting structure is, for example, a staking structure of an organic electroluminescent device, which includes a substrate 2602, an anode layer 2604, a hole transporting layer (HTL) 2606, an electroluminescent layer 2608, an electron transporting layer (ETL) 2610 and a cathode layer 2612. The substrate 2602 is disposed on the magnetic layer 2620, and the anode layer 2604 is disposed on a surface of the substrate 2602. The HTL 2606, the electroluminescent layer 2608 and the ETL 2610 are, for example, stacked between the anode layer 2604 and the cathode layer 2612, where the electroluminescent layer 2608 is disposed between the HTL 2606 and the ETL 2610. The substrate 2602 can be a transparent substrate, for example, a glass substrate. The anode layer 2604 is generally composed of metal or a transparent conductive material (for example, indium tin oxide (ITO), silicon, tin oxide, gold, silver, platinum or copper). In an embodiment, the anode layer 2604 can be a transparent conductive layer including ITO or silicon. The HTL 2606, the electroluminescent layer 2608 and the ETL 2610 cam be respectively composed of an organic material. The cathode layer 2612 can be composed of metal or a transparent conductive material, for example, aluminium, silver or ITO. However, it should be noticed that the disclosure is not limited to the aforementioned materials, and other suitable materials can also be used, which are considered to be within the scope of the disclosure.

In an embodiment, the stacked structure of the light-emitting device 2600 may further include a hole injection layer (HIL) 2614 and an electron injection layer (EIL) 2616. The HIL 2614 is disposed between the HTL 2606 and the anode layer 2604. The EIL 2616 is disposed between the cathode layer 2612 and the ETL 2610. It should be noticed that at least one of the aforementioned layers can be included between the anode layer 2604 and the cathode layer 2612 to implement an organic light-emitting structure, which is not used to limit a scope of the disclosure.

When a bias is applied between the anode layer 2604 and the cathode layer 2612, electrons are injected from the cathode layer 2612 to the ETL 2610, and are transported to the electroluminescent layer 2608, and holes are injected from the anode layer 2604 to the HTL 2606. Moreover, the injected holes are transported to the electroluminescent layer 2608, where the electrons and the holes are recombined to produce excitons to emit light. By applying the magnetic field generated by the magnetic layer 2620 to the light-emitting structure, the exciting binding energy of the material in the light-emitting structure is increased to improve overall light-emitting efficiency of the light-emitting device 2600.

The organic light-emitting device may have another configuration. As shown in FIG. 9, a structure of the light-emitting device 2600a is similar to a structure of the light-emitting device 2600 of FIG. 8, and a difference there between lies in deployment of a magnetic layer 2620a. In an embodiment, a package structure (for example, a flip chip bond) is used to couple the magnetic layer 2620a and the light-emitting structure. In other words, the stacked light-emitting structure and the magnetic layer 2620a can be packaged by installing the cathode layer 2612 to the magnetic layer 2620a, so as to form a flip chip structure. Similarly, the magnetic field generated by the magnetic layer 2620a can increase the exciting binding energy of the material in the light-emitting structure to improve the overall light-emitting efficiency of the light-emitting device 2600a.

Taking a GaN chip as an example, the exciting binding energy thereof is higher than 25.8meV. Besides the applied magnetic field, laser lights of different intensities are input to the GaN chip under a same condition, and photoluminescence (PL) generated by the material of the chip is collected and measured. In case that the magnetic field is applied or not applied, the laser lights of different intensities are input to the GaN chip for testing, and according to the testing results, it is know that the measured PL strength in the light-emitting device in case that the magnetic field is applied is higher than the measured PL strength in the light-emitting device in case that the magnetic field is not applied.

Further, a transparent conductive layer (TCL) is further configured in the light-emitting device to increase current distribution evenness, and several aspects of the TCL have to be considered. The TCL can be disposed on a surface of the P-type layer. Besides a high transmittance of the TCL, an impedance matching between the TCL and the N-type layer is also very important in order to achieve a better effect of current distribution evenness.

In case that the light-emitting device includes the TCL, implementation of impedance matching between the TCL and the N-type layer is determined by various parameters, for example, a resistivity $\rho_t$, a thickness $t_t$ and a carrier mobility $\mu_t$ of the TCL, and a resistivity $\rho_n$ and a carrier mobility $\mu_n$ of the N-type layer. It should be noticed that during an operation period of the light-emitting device, the current only flows in a part of region in the N-type layer close to an interface between the N-type layer and the active layer (i.e. the light-emitting layer). Therefore, a depth $t_{nl}$ of the current path in the N-type layer can also influence implementation of impedance matching, where the depth $t_{nl}$ of the current path is smaller than or equal to a total thickness $t_n$ of the N-type layer.

When the light-emitting device operates without the magnetic field, an original resistance of the TCL is propor-

tional to a parameter $\dfrac{\rho_t}{t_t}$, which is referred to as a resistance parameter in the disclosure, and an original resistance of the N-type layer is proportional to a resistance parameter $\dfrac{\rho_n}{t_{nI}}$ of the N-type layer. Generally, the original resistance

parameter $\dfrac{\rho_t}{t_t}$ of the TCL is not equal to the original resistance parameter $\dfrac{\rho_n}{t_{nI}}$ of the N-type layer. In order to obtain a maximum even distribution area of the current in the light-emitting device, impedance matching between the TCL and the N-type layer is required, for example, a condition of $\dfrac{\rho_t}{t_t} \cong \dfrac{\rho_n}{t_{nI}}$ is required.

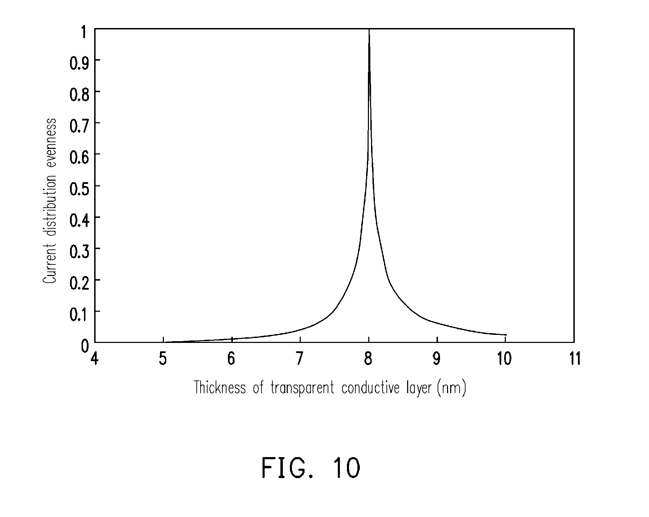

FIG. 10 is distribution curve of a thickness of the TCL in the conventional light-emitting device and current distribution evenness in case that the magnetic field is not applied. As shown in FIG. 10, an alloy of nickel and gold (i.e. Ni/Au) serves as the transparent conductive material in the light-emitting device. When a thickness $t_t$ of the Ni/Au layer is about 80 Å (8nm), the current distribution evenness is equal to 1, which means that the current has a maximum even distribution area. However, the current distribution evenness can be dramatically decreased due to a tiny variation of the thickness $t_t$ of the Ni/Au layer. Namely, a tolerance of the thickness in processing is too small, which cannot be implemented in an actual application. Therefore, the impedance matching cannot be implemented by only adjusting the thickness of the TCL or the thickness of the N-type layer of the conventional light-emitting device.

However, a magnetoresistance effect can be used to implement an overall equivalent impedance matching of the light-emitting device. In case that the magnetic field B is applied, a magnetoresistance $R_b$ is increased and is complied with an equation $R_b(B) = R_0(1+\mu^2B^2)$, where $R_0$ represents an original resistance of the material without applying the magnetic field, and $\mu$ represents a carrier mobility of the material. When the magnetic field $B$ provided by the magnetic material is applied to the light-emitting device, a resistance parameter of the TCL can be represented by a magnetore-

sistance parameter $\dfrac{\rho_t}{t_t}(1+\mu_t^2B^2)$ under the magnetic field, and a magnetoresistance parameter of the N-type layer is represented by $\dfrac{\rho_n}{t_{nI}}(1+\mu_n^2B^2)$. When the magnetoresistance parameter $\dfrac{\rho_t}{t_t}(1+\mu_t^2B^2)$ of the TCL

is substantially equal to the magnetoresistance parameter $\dfrac{\rho_n}{t_{nI}}(1+\mu_n^2B^2)$ of the N-type layer, the impedance matching under the magnetic field can be implemented, i.e. $\dfrac{\rho_t}{t_t}(1+\mu_t^2B^2) \cong \dfrac{\rho_n}{t_{nI}}(1+\mu_n^2B^2)$. In an embodiment,

an approximate equality range of the magnetoresistance parameter of the TCL and the magnetoresistance parameter of the N-type layer can be defined by an equation $\left| \dfrac{\dfrac{\rho_t}{t_t}(1+\mu_t^2B^2) - \dfrac{\rho_n}{t_{nI}}(1+\mu_n^2B^2)}{\dfrac{\rho_t}{t_t}(1+\mu_t^2B^2) + \dfrac{\rho_n}{t_{nI}}(1+\mu_n^2B^2)} \right| \le 0.2$.

In detail, a carrier mobility $\mu_n$ of the N-type layer is generally greater than a carrier mobility $\mu_t$ of the TCL due to an inherent material characteristic. When the original resistance is a constant at both sides of the impedance matching equation, after the constant magnetic field is applied to the light-emitting device, increase of the magnetoresistance parameter of the N-type player is higher than increase of the magnetoresistance parameter of the TCL. Therefore, in an embodiment, when the magnetic field is not applied to the light-emitting device, the original resistance of the TCL is higher than the original resistance of the N-type layer, and a relationship of the magnetoresistance parameters thereof

is, for example, $\dfrac{\rho_t}{t_t} \ge \dfrac{\rho_n}{t_{nI}}$. In an embodiment, an approximate equality relationship of the original resistance parameters of the TCL and the N-type layer is represented by an equation $\dfrac{\left|\dfrac{\rho_t}{t_t} - \dfrac{\rho_n}{t_{nI}}\right|}{\left|\dfrac{\rho_t}{t_t} + \dfrac{\rho_n}{t_{nI}}\right|} \le 0.5$. According to the above descriptions, in case that the magnetic field is applied to the light-emitting device of the disclosure, by finely adjusting respective thickness of the TCL and the N-type layer, a best condition of impedance matching between the TCL and the N-type layer is implemented. Compared to the conventional light-emitting device that has an extremely low thickness tolerance, by applying the magnetic field, the magnetoresistance parameter of the TCL can be easily controlled to be substantially equal to the magnetoresistance parameter of the N-type layer, so that the light-emitting efficiency can be obviously improved.

In an embodiment, a material of the TCL can be metal or semiconductor. When the TCL is composed of metal (for example, Ni/Au), the thickness $t_t$ can be within a range from 50Å to 150Å. When the TCL is composed of semiconductor (for example, ITO or ZnO), the thickness $t_t$ can be within a range from 1000Å to 5000Å. In an embodiment, a material of the N-type layer can be semiconductor, for example, GaAs, a nitride-based material, an In-based material, an Al-based material, a Ga-based material, a Si-based material, or a Pb-based material. The magnetic field B is, for example, greater than 0.01 gauss (G).

Actual applications of the light-emitting device disclosed by the disclosure are introduced below. The following device structures are used to interpret a thickness relationship between the TCL and the N-type layer to facilitate those skilled in the art implementing the disclosure, though the disclosure is not limited thereto. Those skilled in the art should understand that known knowledge of the related art can be used arrange and form the other devices in a way that is not introduced in the aforementioned embodiments.

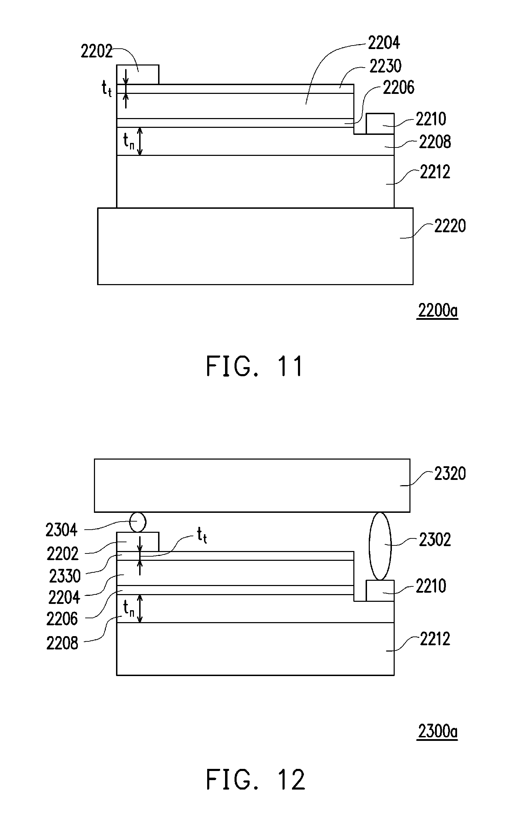

FIG. 11 is a cross-sectional view of a light-emitting device according to an embodiment of the disclosure. Referring to FIG. 11, the light-emitting device 2200a is a horizontal LED, which includes a light-emitting structure coupled to the magnetic material. A structure of the light-emitting device 2200a is similar to that of the light-emitting device 2200 of FIG. 6, and a difference there between lies in configuration of a TCL 2230. The TCL 2230 is disposed on top of the first doped layer 2204 to enhance an effect of current even distribution. The TCL 2230 has the thickness $t_t$, and the second doped layer 2208 (i.e. the N-type layer) has the thickness $t_n$. The thickness $t_t$ and the thickness $t_n$ can be respectively adjusted according to different materials of the TCL 2230 and the second doped layer 2208, such that in case that the magnetic field is applied, the magnetoresistance parameter of the TCL 2230 can be easily controlled to be substantially equal to the magnetoresistance parameter of the second doped layer 2208. Therefore, by applying the magnetic field and adjusting the thickness $t_t$ and the thickness $t_n$, the impedance matching can be implemented to improve the light-emitting efficiency of the light-emitting device 2200a.

FIG. 12 is a cross-sectional view of a light-emitting device according to an embodiment of the disclosure. The same reference numbers in FIG. 11 and FIG. 12 denote the same or like components, and detailed descriptions of the same or similar devices are omitted.

Referring to FIG. 12, the device structure of the light-emitting device 2300a is similar to that of the light-emitting device 2200a of FIG. 11, and a difference there between lies in configuration of a magnetic layer 2320. In an embodiment, a package structure (for example, a flip chip bond) can be used to couple the magnetic layer 2320 and the light-emitting structure. In other words, the first electrode 2202 and the second electrode 2210 of the light-emitting structure can be installed on the magnetic submount 2320. The magnetic submount 2320 is located in the magnetic field of the light-emitting device 2300a, and the impedance matching is implemented to improve the light-emitting efficiency.

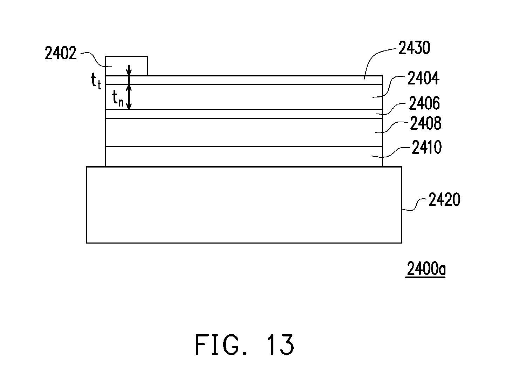

FIG. 13 is a cross-sectional view of a light-emitting device according to an embodiment of the disclosure. Referring to FIG. 13, regarding a thin-film LED having a vertical structure, the light-emitting device 2400a includes a light-emitting structure and a magnetic submount 2420. The light-emitting device 2400a further has a TCL 2430. The TCL 2430 is, for example, disposed on top the second doped layer 2404 to enhance an effect of current even distribution. The TCL 2430 has the thickness $t_t$, and the second doped layer 2404 (i.e. the N-type layer) has the thickness $t_n$. The thickness $t_t$ and the thickness $t_n$ can be respectively adjusted according to different materials of the TCL 2430 and the second doped layer 2404, so as to implement the impedance matching. Therefore, by applying the magnetic field and adjusting the thickness $t_t$ and the thickness $t_n$, the impedance matching can be implemented to improve the light-emitting efficiency of the light-emitting device 2400a.

Moreover, when the light-emitting device is an organic light-emitting device, an anode thereof can be formed by the TCL. Taking the light-emitting devices 2600 and 2600a of FIG. 8 and FIG. 9 as an example, the anode layer 2604 has the thickness $t_t$, and the ETL 2610 and the EIL 2616 (i.e. the N-type layer) commonly have the thickness $t_n$. The thickness $t_t$ and the thickness $t_n$ can be respectively adjusted according to different materials of the anode layer 2604, the ETL 2610 and the EIL 2616, such that in case that the magnetic field is applied, the magnetoresistance parameter of the TCL can be easily controlled to be substantially equal to the magnetoresistance parameter of the N-type layer. Therefore, by applying the magnetic field and adjusting the thickness $t_t$ and the thickness $t_n$, the impedance matching can be implemented to improve the light-emitting efficiency of the light-emitting device 2600 or 2600a.

In an embodiment, when the light-emitting device 2600 or 2600a includes the HTL 2606, the electroluminescent layer 2608 and the ETL 2610 stacked between the anode layer 2604 and the cathode layer 2612 without including the HIL 2614 and the EIL 2616, the thickness $t_n$ of the N-type layer only refers to the thickness of the ETL 2610. It should be noticed that at least one of the aforementioned layers can be included between the anode layer 2604 and the cathode layer 2612 to implement the organic light-emitting device, which is not used to limit a scope of the disclosure. Therefore, the thickness $t_t$ and the thickness $t_n$ can be modified according to respective arrangement of the TCL and the N-type layer.

In the light-emitting device provided by the disclosure, in case that the magnetic field is applied, by suitably control the thickness $t_t$ and the thickness $t_n$, the light-emitting efficiency is effectively improved. The provided embodiments are only used to describe effects on positive voltage and light output power generated due to deployment of the magnetic material, which are not used to limit the disclosure.

In case that the exciting binding energy of the semiconductor material of the light-emitting device is increased, improvement of the IQE and carrier recombination is enhanced. Therefore, the light-emitting efficiency of the light-emitting device is effectively improved.

Moreover, in case that the magnetic field is applied, respective thickness of the TCL and the N-type layer can be easily adjusted to substantially equalize the magnetoresistance parameters of the TCL and the N-type layer. Since the magnetic field can be used to implement the impedance matching of the TCL and the N-type layer, a maximum even distribution area of the current in the light-emitting device is obtained. Therefore, the current distribution evenness and the light-emitting efficiency of the light-emitting device can be effectively improved.

Further, by applying the magnetic field to the light-emitting device according to the aforementioned methods, the light-emitting efficiency and luminance of the light-emitting device can be effectively increased.

Moreover, considering the resistance matching between the TCL and the N-type layer, there are various design variations. In detail, the resistances of the TCL and the N-type layer may have different resistance differences as the current flowing path varies, which may lead to resistance mismatching. If the resistances are not matched, the light-emitting efficiency is decreased. In the disclosure, a magnetic field is used to produce magnetoresistance to flexibly adjust matched resistances. In an actual application, shapes of electrode structures can be suitably design to even the current, so as to reduce current loss and unevenness caused by the resistance mismatching.

Embodiments of the light-emitting device package structure with the magnetic element of the disclosure are introduced below, though the embodiments are only examples, which are not used to limit the disclosure. Moreover, technical features of the following different embodiments can be arbitrarily combined.

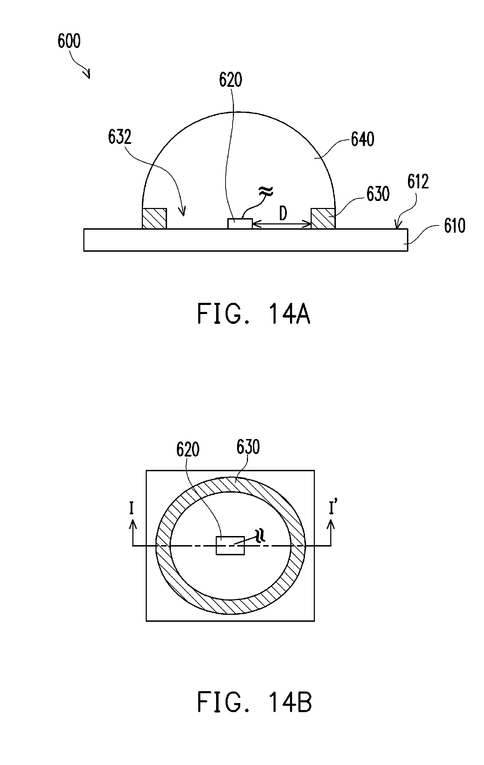

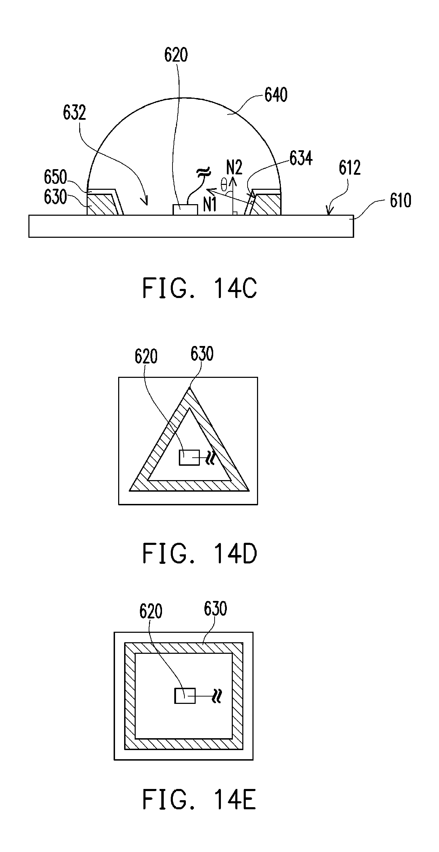

FIG. 14A is a cross-sectional view of a light-emitting device package structure according to an embodiment of the disclosure. FIG. 14B is a top view of FIG. 14A, where FIG. 14A is a cross-sectional view of FIG. 14B along a line I-I'. FIG. 14C-FIG. 14M illustrate a plurality of variations of the light-emitting device package structure of FIG. 14A. It should be noticed that for simplicity's sake, an encapsulant is omitted in FIG. 14D-FIG. 14M.

Referring to FIG. 14A and FIG. 14B, the light-emitting device package structure 600 of the embodiment includes a carrier 610, a light-emitting device 620, a magnetic element 630 and an encapsulant 640. The light-emitting device 620 is disposed on a plane 612 of the carrier 610, and the carrier 610 is, for example, a ceramic submount, a silicon submount, an aluminium submount, a copper submount, a high thermal conductive submount or a circuit board. Since a magnitude of the magnetic field applied on the light-emitting device 620 by the magnetic element 630 is inversely proportional to distance, a minimum space D between the magnetic element 630 and the light-emitting device 620 is, for example, smaller than or equal to 5 centimetres (cm). In the embodiment, the minimum space D between the magnetic element 630 and the light-emitting device 620 is smaller than or equal to 3 cm.

The so-called "minimum space between the magnetic element and the light-emitting chip" refers to a shortest distance between a peripheral sidewall of the chips and the magnetic element when the package has multiple chips. Namely, the light-emitting device 620 can be composed of a plurality of light-emitting chips.

It should be noticed that since the magnetic element 630 of the embodiment is located at peripheral of the light-emitting device 620, the magnetic element 630 can apply a magnetic field on the light-emitting device 620 to improve the current distribution evenness of the light-emitting device 100 when the light-emitting device package structure 600 operates. In this way, usage of the magnetic element 630 avails improving the light-emitting efficiency and light-emitting evenness of the light-emitting device package structure 600 of the embodiment.

In the embodiment, the magnetic element 630 is a ring-shape structure, and the light-emitting device 620 is disposed in an opening 632 of the magnetic element 630. In order to facilitate the magnetic element 630 effectively reflecting the light emitted by the light-emitting device 620, the magnetic element 630 may have a slant 634 facing to the top of the light-emitting device 620 (shown in FIG. 14C), where an included angle θ between a normal vector N1 of the slant 634 and a normal vector N2 of the plane 612 of the carrier 610 is smaller than 90 degrees, and a reflection layer 650 is disposed on the slant 634 to reflect the light emitted by the light-emitting device 620. In the embodiment, the encapsulant 640 covers the light-emitting device 620, and the magnetic element 630 is disposed at an edge of the encapsulant 640.

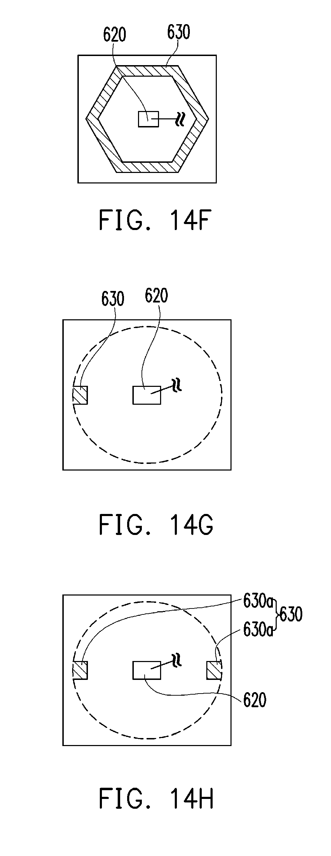

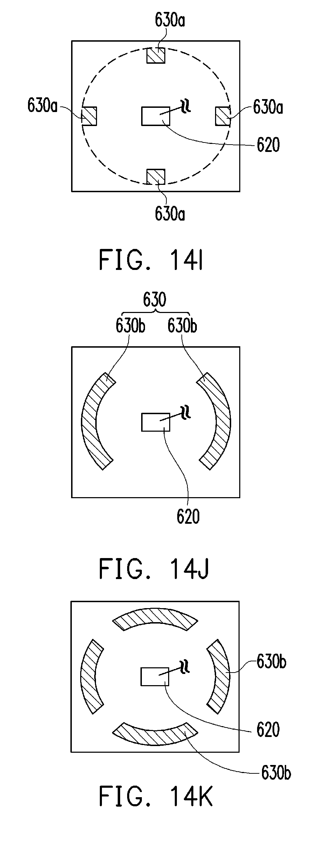

In the embodiment, the magnetic element 630 has a ring shape. In other embodiments, the magnetic element 630 may selectively have a shape of a triangle ring (FIG. 14D), a square ring (FIG. 14E), a hexagonal ring (FIG. 14F), other polygon ring or other irregular-shaped ring. Moreover, in other embodiments, the magnetic element 630 can be a block-like structure (FIG. 14G), a plurality of block-like structures (FIG. 14H and FIG. 14I), or one or a plurality of bar-shape structures (FIG. 14J and FIG. 14K).

When the magnetic element 630 has a plurality of block-like structures 630a, the block-like structures 630a can be selectively disposed at two opposite sides of the light-emitting device 620 (FIG. 14H), or selectively surround the light-emitting device 620 (FIG. 14I). When the magnetic element 630 has a plurality of bar-shape structures 630b, the bar-shape structures 630b can be selectively disposed at two opposite sides of the light-emitting device 620 (FIG. 14J), or selectively surround the light-emitting device 620 (FIG. 14K).

In the embodiment, the magnetic element 630 is composed of a magnetic material, and the magnetic material is, for example, a hard magnetic material. Moreover, the magnetic material can also be a ferromagnetic material such as Rb, Ru, Nd, Fe, Pg, Co, Ni, Mn, Cr, Cu, $Cr_2$, Pt, Sm, Sb, Pt or other alloys. The magnetic material can also be a ceramic material such as oxide of Mn, Fe, Co, Cu and V, fluoride of $Cr_2O_3$, CrS, MnS, MnSe, MnTe, Mn, Fe, Co or Ni, chloride of V, Cr, Fe, Co, Ni and Cu, bromide of Cu, CrSb, MnAs, MnBi, $\alpha$-Mn, $MnCl_2$, $4H_2O$, $MnBr_2$, $4H_2O$, $CuCl_2$, $2H_2O$, $Co(NH_4)x(SO_4)xCl_2.6H_2O$, $FeCo_3$ and $FeC0_3.2MgCO_3$.

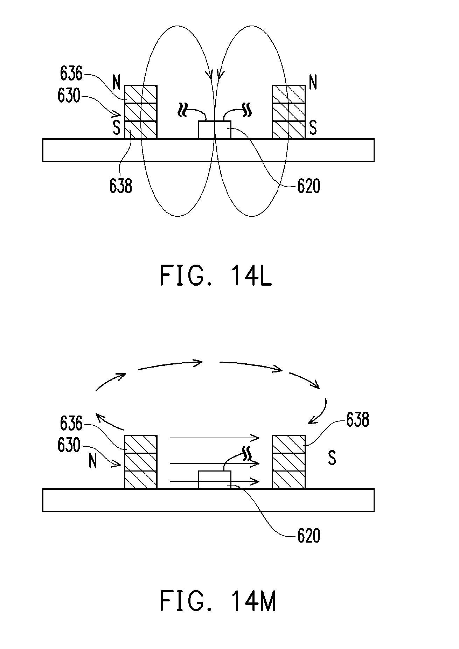

Moreover, in the embodiment, when an N-pole 636 and an S-pole 638 of the magnetic element 630 are vertically arranged, the magnetic element 630 can apply a near vertical magnetic field (FIG. 14L) on the light-emitting device 620, and when the N-pole 636 and the S-pole 638 of the magnetic element 630 are horizontally arranged, the magnetic element 630 can apply a near horizontal magnetic field (FIG. 14M) on the light-emitting device 620.

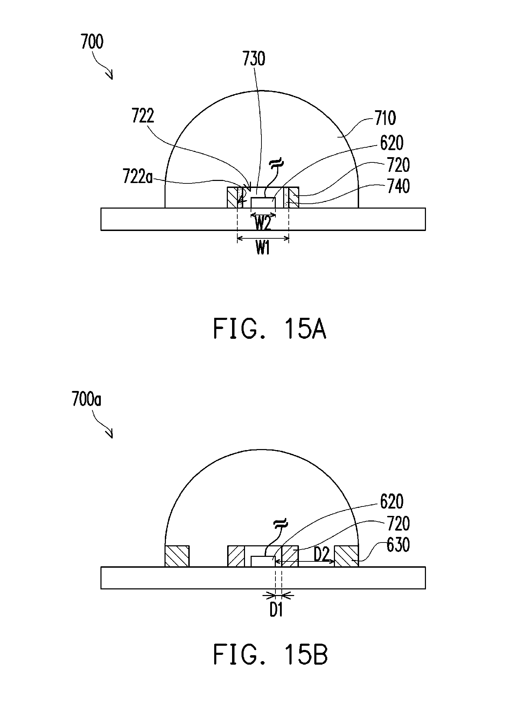

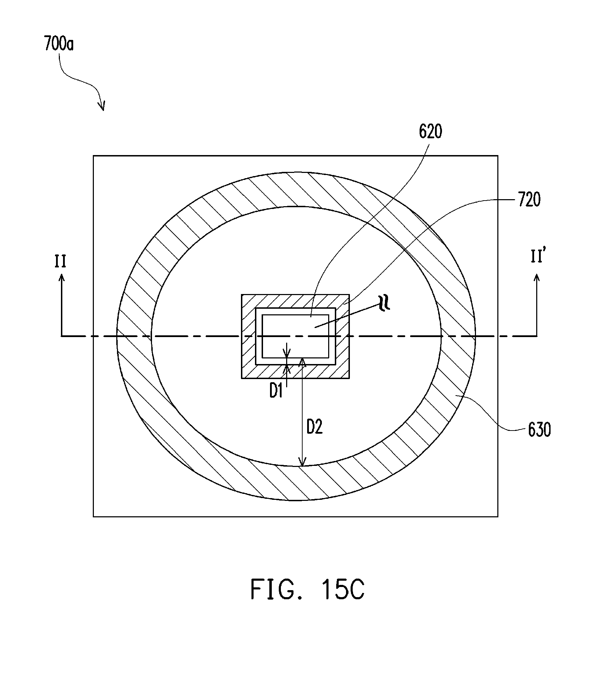

FIG. 15A is a cross-sectional view of a light-emitting device package structure according to an embodiment of the disclosure. FIG. 15B is a variation of the light-emitting device package structure of FIG. 15A. FIG. 15C is a top view of the light-emitting device package structure of FIG. 15B, and FIG. 15B is a cross-sectional view of FIG. 15C along a line II-II'.

Referring to FIG. 15A, the light-emitting device package structure 700 of the embodiment is similar to the light-emitting device package structure 600 of FIG. 14A, and a difference there between is that an encapsulant 710 of the light-emitting device package structure 700 fully covers a magnetic element 720. In the embodiment, when the magnetic element 720 is a ring-shape structure, a difference X between a width W1 of an opening 722 of the magnetic element 720 and a width W2 of the light-emitting device 620 is, for example, $1<X\leq1.5$, and a fluorescent material 730 is selectively disposed in the opening 722 to cover the light-emitting device 620.

Moreover, in the embodiment, an optimal film layer 740 can be formed on an inner wall 722a of the opening 722, and the optical film layer 740 can be a reflection layer or a light-absorbing layer. When the optical film layer 740 is a reflection layer, the reflection layer can reflect the light irradiated to the inner wall 722a of the opening 722 by the light-emitting device 620 to improve a light usage rate of the light-emitting device 620. When the optical film layer 740 is a light-absorbing layer, the light-absorbing layer can absorb the light irradiated to the inner wall 722a of the opening 722 by the light-emitting device 620 to uniform a light-emitting direction of the light-emitting device package structure 700.

Moreover, the light-emitting device package structure 700 can be combined to the magnetic element 630 of FIG. 14A to obtain a light-emitting device package structure 700a of FIG. 15B and FIG. 15C, and a minimum space D1 between the light-emitting device 620 and the magnetic element 720 of the light-emitting device package structure 700a can be smaller than a minimum space D2 between the light-emitting device 620 and the magnetic element 630. It should be noticed that the light-emitting device package structure 700a simultaneously have the magnetic element 720 and the magnetic element 630.

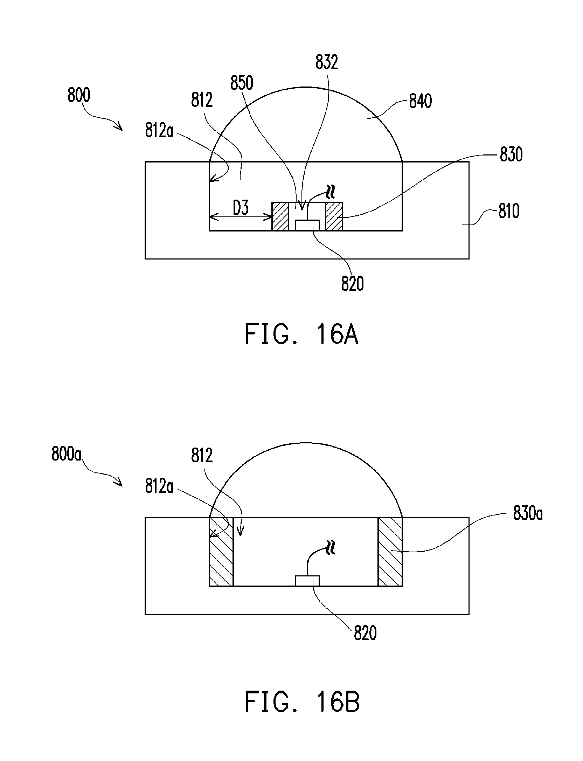

FIG. 16A is a cross-sectional view of a light-emitting device package structure according to an embodiment of the disclosure. FIG. 16B-16D are variations of the light-emitting device package structure of FIG. 16A.

Referring to FIG. 16A, the light-emitting device package structure 800 includes a carrier 810, a light-emitting device 820, a magnetic element 830 and an encapsulant 840, where the carrier 810 is, for example, a plate-like structure. The carrier 810 may have a groove 812, and the light-emitting device 820 is disposed in the groove 812. The magnetic element 830 can be selectively disposed on the carrier 810 and located in the groove 812, and the magnetic element 830 is located at peripheral of the light-emitting device 820, and a space D3 is formed between an inner wall 812a of the groove 812 and the magnetic element 830. In the embodiment, the magnetic element 830 is, for example, a ring-shape structure, and the light-emitting device 820 is located in an opening 832 of the magnetic element 830. Moreover, in order to adjust a color of the light emitted by the light-emitting device package structure 800, a fluorescent material 850 can be filled in the opening 832 of the magnetic element 830 to cover the light-emitting device 820. The encapsulant 840 can be formed on the fluorescent material 850 to serve as an optical lens.

Referring to FIG. 16B, the light-emitting device package structure 800a of the embodiment is similar to the light-emitting device package structure 800 of FIG. 16A, and a difference there between is that a magnetic element 830a of the light-emitting device package structure 800a is adhered to the inner wall 812a of the groove 812.

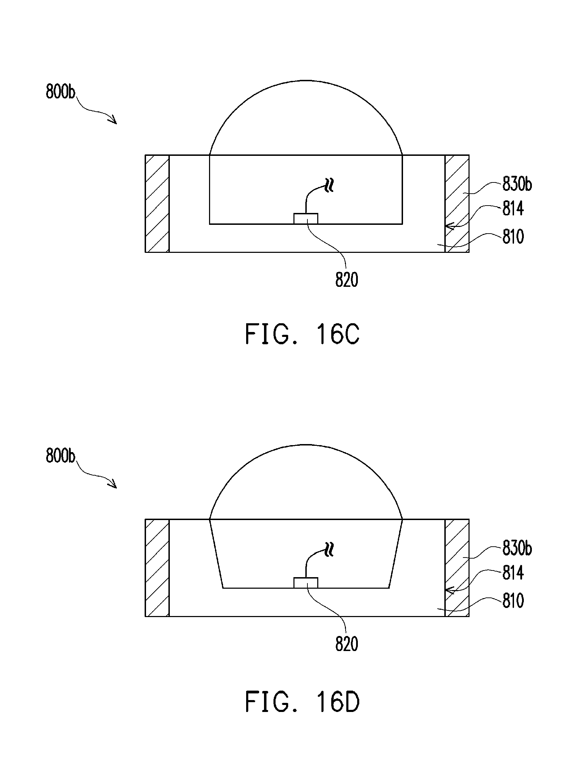

Referring to FIG. 16C, the light-emitting device package structure 800b of the embodiment is similar to the light-emitting device package structure 800 of FIG. 16A, and a difference there between is that a magnetic element 830b of the light-emitting device package structure 800b is disposed on a sidewall 814 of the carrier 810.

Referring to FIG. 16D, the embodiment of FIG. 16C is taken as an example for variation, and in the aforementioned embodiments, the inner wall 812a may also have a slant design, so that the emitted light is more concentrated and directional.

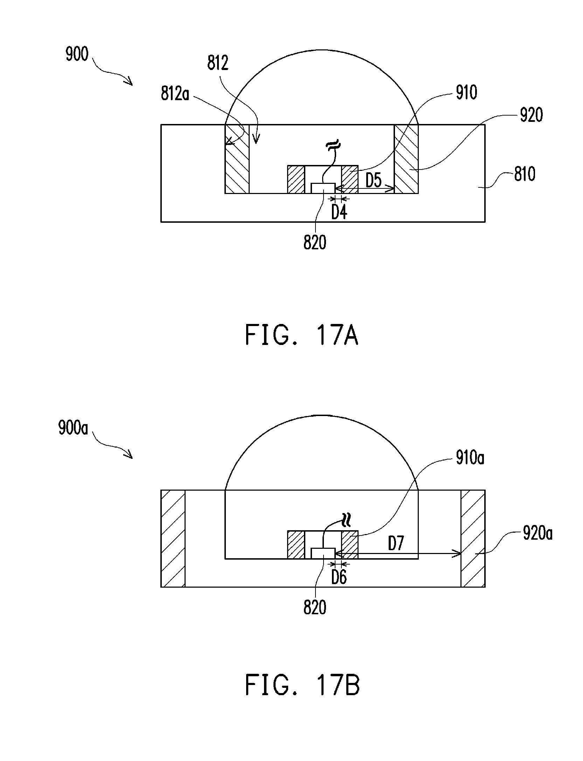

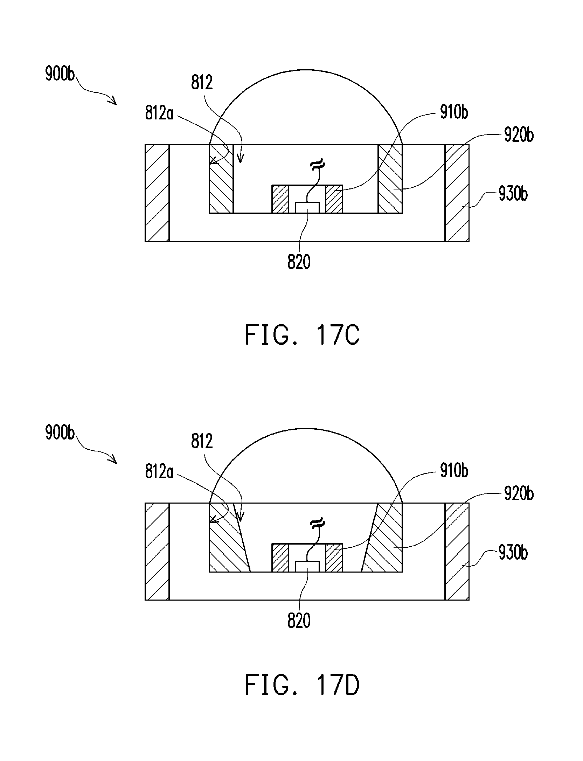

FIG. 17A, FIG. 17B and FIG. 17C are respectively three variations of FIGs. 16A-16C.

Referring to FIG. 17A, the light-emitting device package structure 900 of the embodiment is similar to the light-emitting device package structures 800 and 800a of FIG. 16A and FIG. 16B, and a difference there between is that the light-emitting device package structure 900 simultaneously have two magnetic elements 910 and 920, where a configuration position of the magnetic element 910 is the same to a configuration position of the magnetic element 830 of FIG. 16A, and a configuration position of the magnetic element 920 is the same to a configuration position of the magnetic element 830a of FIG. 16B. In the embodiment, a minimum space D4 between the light-emitting device 820 and the magnetic element 910 is smaller than a minimum space D5 between the light-emitting device 820 and the magnetic element 920. In detail, in the embodiment, the magnetic element 910 is located between the light-emitting device 820 and the magnetic element 920.

In the embodiment, since the light-emitting device package structure 900 simultaneously have the magnetic elements 910 and 920, compared to the light-emitting device package structure 800 or 800a that only has a single magnetic element 830 or 830a, the magnetic elements 910 and 920 in the light-emitting device package structure 900 may use a material with lower magnetic strength.

Referring to FIG. 17B, the light-emitting device package structure 900a of the embodiment is similar to the light-emitting device package structures 800 and 800b of FIG. 16A and FIG. 16C, and a difference there between is that the light-emitting device package structure 900a simultaneously have two magnetic elements 910a and 920a, where a configuration position of the magnetic element 910a is the same to a configuration position of the magnetic element 830 of FIG. 16A, and a configuration position of the magnetic element 920a is the same to a configuration position of the magnetic element 830b of FIG. 16C. In the embodiment, a minimum space D6 between the light-emitting device 820 and the magnetic element 910a is smaller than a minimum space D7 between the light-emitting device 820 and the magnetic element 920a. In detail, in the embodiment, the magnetic element 910a is located between the light-emitting device 820 and the magnetic element 920a.

Referring to FIG. 17C, the light-emitting device package structure 900b of the embodiment is similar to the light-emitting device package structures 800, 800a and 800b of FIGs. 16A-16C, and a difference there between is that the light-emitting device package structure 900b simultaneously have three magnetic elements 910b, 920b and 930b, where a configuration position of the magnetic element 910b is the same to a configuration position of the magnetic element 830 of FIG. 16A, a configuration position of the magnetic element 920b is the same to a configuration position of the magnetic element 830a of FIG. 16B, and a configuration position of the magnetic element 930b is the same to a configuration position of the magnetic element 830b of FIG. 16C. In the embodiment, the magnetic element 920b is located between the magnetic element 910b and the magnetic element 930b, and the magnetic element 910b is closest to the light-emitting device 820.

The sidewall of the magnetic element that faces to the light-emitting device may also have a slanted structure besides a vertical configuration. The slanted structure avails concentrating the light and increasing a lighting intensity. FIG. 17D is a schematic diagram of a light-emitting device package structure according to another embodiment of the disclosure. Referring to FIG. 17D, the embodiment of FIG. 17C is taken as an example for variation, for example, the magnetic element 920b may have a slanted inner wall design. Further, the embodiment of FIG. 17D is not a unique method for the slanted inner wall design, which can also be a slanted groove, and the magnetic element has a design of equal thickness. In other words, the slant of the sidewall of the magnetic element can be adjusted according to an actual requirement.

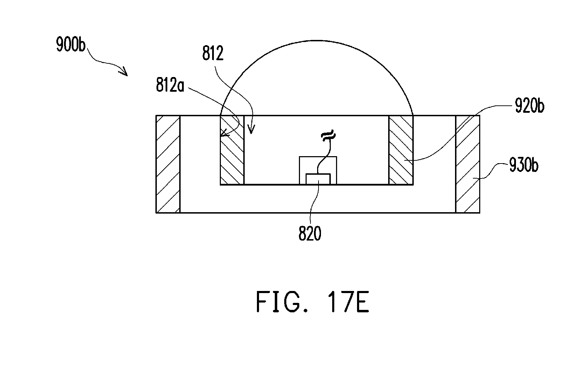

Further, the inner, middle and outer magnetic elements may have various combinations, for example, only the middle and the outer magnetic elements can be used without using the inner magnetic element 910b, as that shown in FIG. 17E.

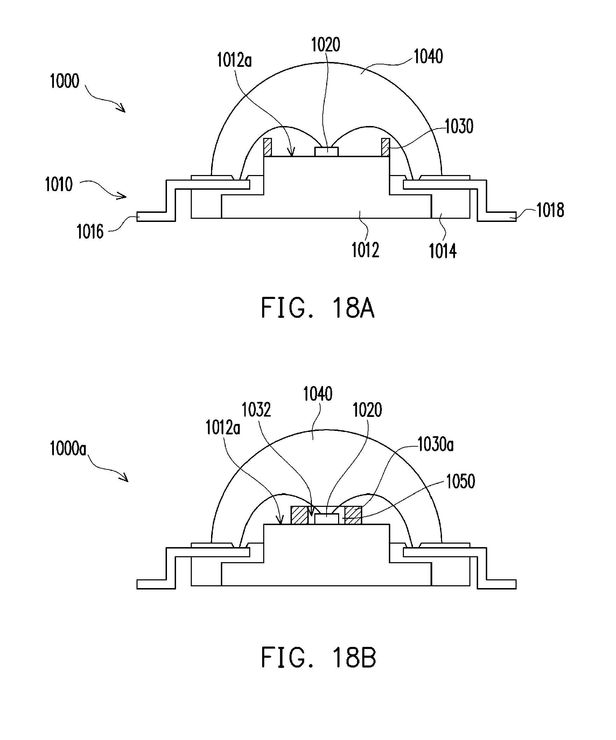

FIG. 18A is a cross-sectional view of a light-emitting device package structure according to an embodiment of the disclosure. FIGs. 18B-18E are four variations of the light-emitting device package structure of FIG. 18A.

Referring to FIG. 18A, the light-emitting device package structure 1000 of the embodiment includes a carrier 1010, a light-emitting device 1020, a magnetic element 1030 and an encapsulant 1040, where the carrier 1010 includes a substrate 1012, a casing 1014, a first pin 1016 and a second pin 1018, where a material of the substrate 1012 has a high thermal conductivity, which is, for example, metal.

A material of the casing 1014 is an insulation material, and the casing 1014 covers a part of the substrate 1012, a part of the first pin 1016 and a part of the second pin 1018, and insulates the substrate 1012, the first pin 1016 and the second pin 1018. The light-emitting device 1020 is disposed on a surface 1012a of the substrate 1012 that is not covered by the casing 1014, and heat generated by the light-emitting device 1020 during operation can be transmitted to external through the substrate 1012 to achieve a quick cooling effect. The magnetic element 1030 is disposed on the surface 1012a of the substrate 1012 and is located at peripheral of the light-emitting device 1020. The encapsulant 1040 selectively covers the light-emitting device 1020 and the magnetic element 1030.

In the embodiment, since the magnetic element 1030 can apply a magnetic field on the light-emitting device 1020, the substrate 1012 assists cooling the light-emitting device 1020, and the light-emitting device 1020 can be electrically connected to the first pin 1016 and the second pin 1018, there are three relationships of electricity, heat and magnetism respectively between the first and the second pins 1016 and 1018, the substrate 1012 and the magnetic element 1030 and the light-emitting device 1020. In the embodiment, since the first and the second pins 1016 and 1018, the substrate 1012 and the magnetic element 1030 can independently operate without mutual relation, the light-emitting device package structure 1000 is a package structure with separated electricity, heat and magnetism.

Referring to FIG. 18B, the light-emitting device package structure 1000a of the embodiment is similar to the light-emitting device package structure 1000 of FIG. 18A, and a difference there between is that the magnetic element 1030a of the light-emitting device package structure 1000a is closer to the light-emitting device 1020. Therefore, when the magnetic element 1030a has a ring-shape structure, an opening 1032 of the magnetic element 1030a can be used to define a fluorescent material coating area of the surface 1012a. In the embodiment, a fluorescent material 1050 is filled in the opening 1032 to cover the light-emitting device 1020. The encapsulant 1040 can cover the light-emitting device 1020, the fluorescent material 1050 and the magnetic element 1030a.

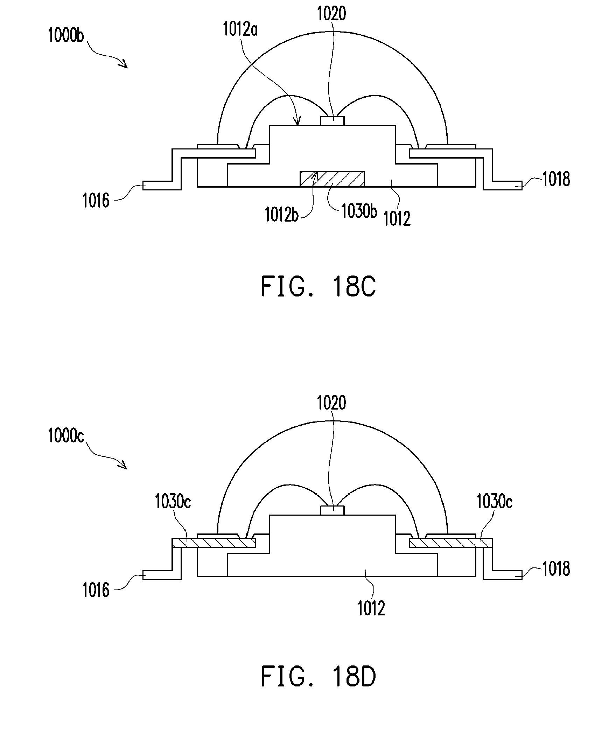

Referring to FIG. 18C, the light-emitting device package structure 1000b of the embodiment is similar to the light-emitting device package structure 1000 of FIG. 18A, and a difference there between is that the magnetic element 1030b of the light-emitting device package structure 1000b is disposed on a surface 1012b of the substrate 1012 opposite to the surface 1012a. In other words, the substrate 1012 is located between the light-emitting device 1020 and the magnetic element 1030b. In the embodiment, magnetic lines of force of the magnetic element 1030b have to penetrate through the substrate 1012 in order to apply a magnetic field on the light-emitting device 1020, and the substrate 1012 transmits the heat to external through the magnetic element 1030b, and the first and the second pins 1016 and 1018 can operate independently relative to the magnetic element 1030b and the substrate 1012, so that the light-emitting device package structure 1000b is a package structure with integrated heat and magnetism and separated electricity.

Referring to FIG. 18D, the light-emitting device package structure 1000c of the embodiment is similar to the light-emitting device package structure 1000 of FIG. 18A, and a difference there between is that the magnetic element 1030c of the light-emitting device package structure 1000c is disposed on the first pin 1016 and the second pin 1018, where the magnetic element 1030c can be disposed on the pins as a device or can serve as a conductive material to replace a portion of the pins. As described above, the first and the second pins 1016 and 1018 are electrically connected to the light-emitting device 1020 through the magnetic element 1030c, and the substrate 1012 can transmit the heat to external independently relative to the magnetic element 1030c and the first and the second pins 1016 and 1018, so that the light-emitting device package structure 1000b is a package structure with integrated electricity and magnetism and separated heat.

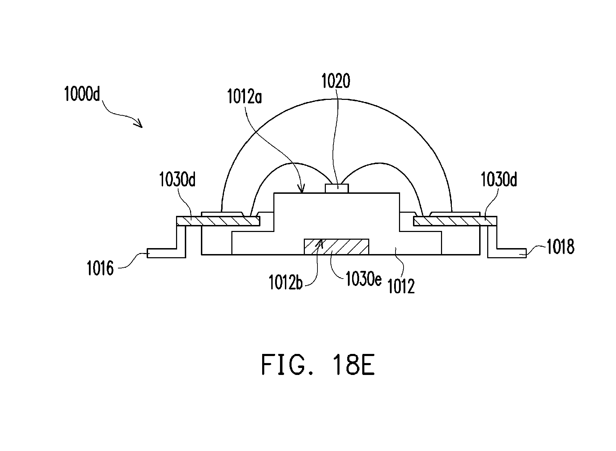

Referring to FIG. 18E, the light-emitting device package structure 1000d of the embodiment is similar to the light-emitting device package structure 1000 of FIG. 18A, and a difference there between is that the light-emitting device package structure 1000d has two magnetic elements 1030d and 1030e, where the magnetic element 1030d is disposed on the first and the second pins 1016 and 1018, and the magnetic element 1030e is disposed on the surface 1012b of the substrate 1012 opposite to the surface 1012a. In detail, in the embodiment, a part of the magnetic element 1030e is embedded in the substrate 1012.

In the embodiment, since the first and the second pins 1016 and 1018 are electrically connected to the light-emitting device 1020 through the magnetic element 1030d, the magnetic lines of force of the magnetic element 1030e have to penetrate through the substrate 1012 in order to apply a magnetic field on the light-emitting device 1020, and the substrate 1012 transmits the heat to external through the magnetic element 1030e, the light-emitting device package structure 1000d is a package structure with integrated electricity and magnetism and integrated heat and magnetism.

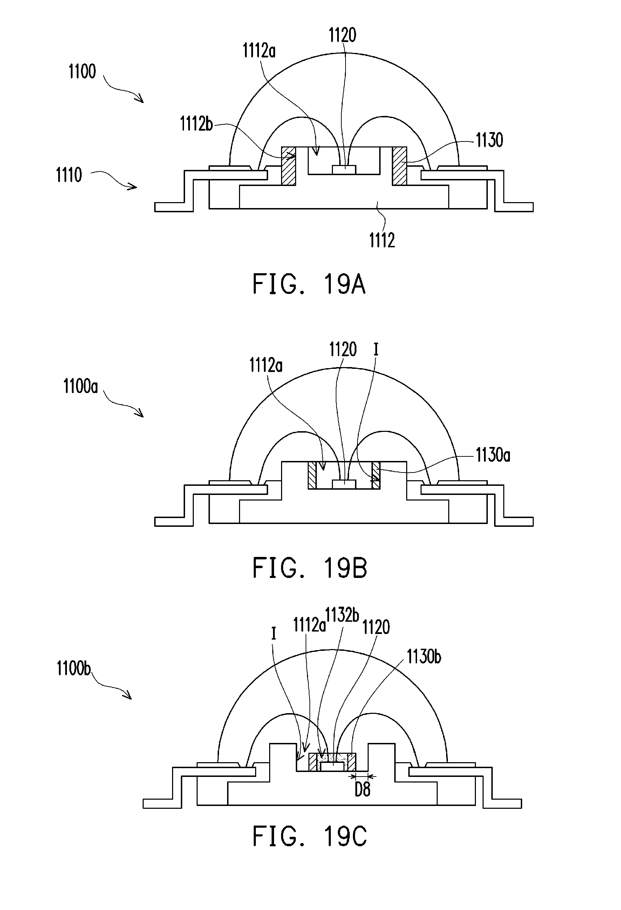

FIG. 19A is a cross-sectional view of a light-emitting device package structure according to an embodiment of the disclosure. FIG. 19B and FIG. 19C are two variations of the light-emitting device package structure of FIG. 19A.

Referring to FIG. 19A, the light-emitting device package structure 1100 of the embodiment is similar to the light-emitting device package structure 1000 of FIG. 18A, and a difference there between is that a substrate 1112 of the light-emitting device package structure 1100 has a groove 1112a, a light-emitting device 1120 is located in the groove 1112a, and a magnetic element 1130 is adhered to a sidewall 1112b of the substrate 1112 and located at peripheral of the light-emitting device 1120.

Referring to FIG. 19B, the light-emitting device package structure 1100a of the embodiment is similar to the light-emitting device package structure 1100 of FIG. 19A, and a difference there between is that a magnetic elements 1130a of the light-emitting device package structure 1100a is located in the groove 1112a and is adhered to an inner wall I of the groove 1112a.

Referring to FIG. 19C, the light-emitting device package structure 1100b of the embodiment is similar to the light-emitting device package structure 1100 of FIG. 19A, and a difference there between is that a magnetic elements 1130b of the light-emitting device package structure 1100b is located in the groove 1112a, and a space D8 is maintained between the magnetic element 1130b and the inner wall I of the groove 1112a. When the magnetic element 1130b is a ring-shape structure, an opening 1132b of the magnetic element 1130b can define a fluorescent material coating area.

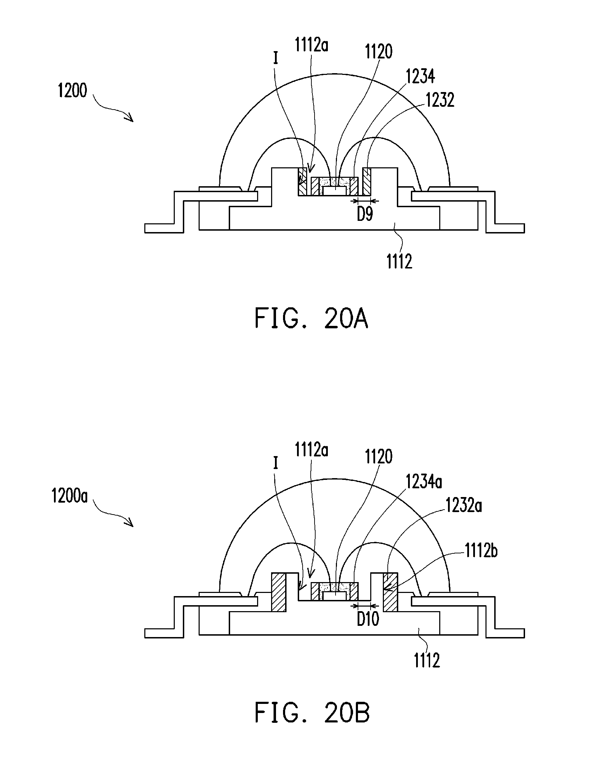

FIGs. 20A-20C are three variations of FIGs. 19A-19C.

Referring to FIG. 20A, the light-emitting device package structure 1200 of the embodiment is similar to the light-emitting device package structures 1100a and 1100b of FIG. 19B and FIG. 19C, and a difference there between is that the light-emitting device package structure 1200 simultaneously have two magnetic elements 1232 and 1234, and the magnetic elements 1232 and 1234 are located in the groove 1112a of the substrate 1112. The magnetic element 1232 is adhered to the inner wall I of the groove 1112a, and a space D9 is maintained between the magnetic element 1234 and the inner wall I of the groove 1112a, where the magnetic element 1234 is located between the light-emitting device 1120 and the magnetic element 1232.

Referring to FIG. 20B, the light-emitting device package structure 1200a of the embodiment is similar to the light-emitting device package structures 1100 and 1100b of FIG. 19A and FIG. 19C, and a difference there between is that the light-emitting device package structure 1200a has two magnetic elements 1232a and 1234a, and the magnetic element 1232a is located on the sidewall 1112b of the substrate 1112 and located at peripheral of the light-emitting device 1120, and the magnetic element 1234a is located in the groove 1112a, and a space D10 is maintained between the magnetic element 1234a and the inner wall I of the groove 1112a.

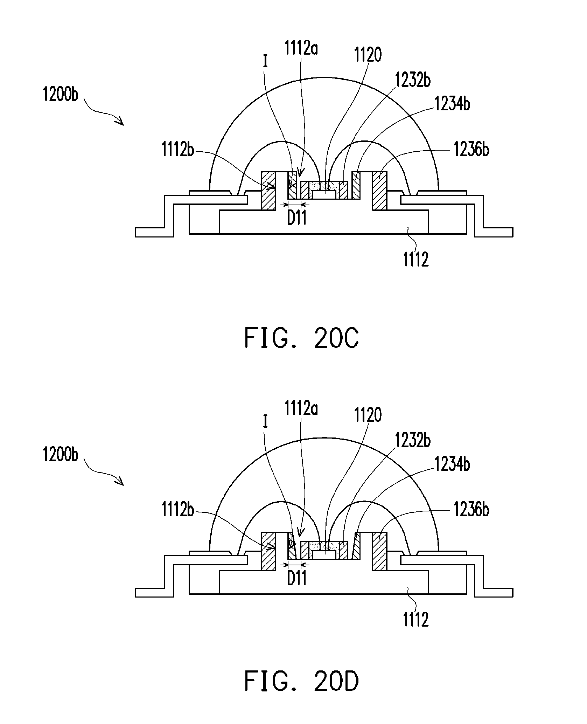

Referring to FIG. 20C, the light-emitting device package structure 1200b of the embodiment is similar to the light-emitting device package structures 1100, 1100a and 1100b of FIGs. 19A-19C, and a difference there between is that the light-emitting device package structure 1200b has three magnetic elements 1232b, 1234b and 1236b, where the magnetic element 1232b is located in the groove 1112a, and a space D11 is maintained between the magnetic element 1232b and the inner wall I of the groove 1112a, the magnetic element 1234b is located in the groove 1112a and is adhered to the inner wall I of the groove 1112a, and the magnetic element 1236b is located on the sidewall 1112b of the substrate 1112. The magnetic element 1234b is located between the magnetic element 1232b and the magnetic element 1236b, and the magnetic elements 1232b, 1234b and 1236b are all located at peripheral of the light-emitting device 1120.

The sidewall of the magnetic element that faces to the light-emitting device may also have a slanted structure besides a vertical configuration. The slanted structure avails concentrating the light and increasing a lighting intensity. FIG. 20D is a schematic diagram of a light-emitting device package structure according to another embodiment of the disclosure. Referring to FIG. 20D, the embodiment of FIG. 20C is taken as an example for variation, for example, the magnetic element 1234b may have a slanted inner wall design. Further, the embodiment of FIG. 20D is not a unique method for the slanted inner wall design, which can also be a slanted groove, and the magnetic element has a design of equal thickness. In other words, the slant of the sidewall of the magnetic element can be adjusted according to an actual requirement.

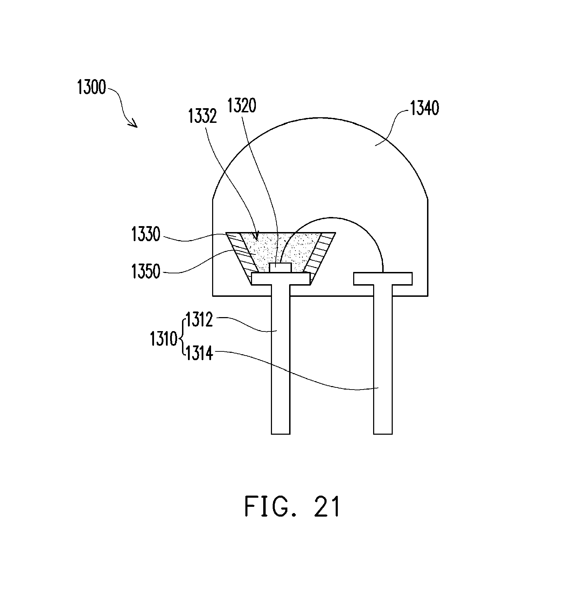

FIG. 21 is a cross-sectional view of a light-emitting device package structure according to an embodiment of the disclosure.

Referring to FIG. 21, the light-emitting device package structure 1300 of the embodiment includes a carrier 1310, a light-emitting device 1320, a magnetic element 1330 and an encapsulant 1340, where the carrier 1310 can be a lead frame, and the lead frame includes two pins 1312 and 1314 independent to each other, and the magnetic element 1330 can be a cup-like structure and disposed on the pin 1312. The magnetic element 1330 has an opening 1332, and the opening 1332 exposes a part of the pin 1312. The light-emitting device 1320 is disposed on the pin 1312 and located in the opening 1332, and is electrically connected to the pins 1312 and 1314. Moreover, in order to adjust the color of the light emitted by the light-emitting device package structure 1300, a fluorescent material 1350 can be filled in the groove 1332 to cover the light-emitting device 1320. The encapsulant 1340 covers the light-emitting device 1320, the magnetic element 1330, the fluorescent material 1350 and a part of the pins 1312 and 1314.

Further, the pin 1312 can also be composed of a magnetic material to serve as a magnetic element, which may produce a forward magnetic force. Moreover, in collaboration with other magnetic elements that produce a lateral magnetic force, an effect of applying the forward magnetic force and the lateral magnetic force is achieved.

According to the aforementioned embodiments, it is known that as long as the magnetic element is disposed at peripheral of the light-emitting device, an effect of applying the magnetic field on the light-emitting device is achieved. Therefore, the magnetic element can be arbitrarily disposed at peripheral regions (such as above, under or to the side) of the light-emitting device, or the magnetic element can also be located outside the light-emitting device package structure (which is not illustrated), and a plurality of magnetic elements of different positions can be simultaneously configured, so as to strengthen the effect of applying the magnetic field to the light-emitting device.

Since the magnetic element is disposed at the peripheral of the light-emitting device, a magnetic field is applied on the light-emitting device, so that when the light-emitting device package structure operates, the current distribution evenness of the light-emitting device is improved. In this way, usage of the magnetic element avails improving the overall light-emitting efficiency and the light-emitting evenness of the light-emitting device package structure.

In the aforementioned descriptions, the magnetic material refers to a material that produces the magnetic field, for example, a ferromagnetic material, etc. In the disclosure, the light-emitting device also has a characteristic of weak magnetism, where the weak magnetism includes soft magnetism, paramagnetism, and diamagnetism, etc., and the material itself may produce a stronger magnetic field intensity due to induction of the external magnetic field. When the external magnetic field is applied on the light-emitting device, due to the characteristic of weak magnetism, the magnetic field actually produced at the light-emitting device can be larger compared to the applied magnetic field. Embodiments are provided below for detail descriptions. As described above, the disclosure is not limited to the provided embodiments, and the provided embodiments can be suitably combined.

The disclosure provides a magnetic light-emitting device and a magnetic light-emitting apparatus having the light-emitting device, in which at least one of a first semiconductor layer, a second semiconductor layer and a conductive layer contains a weak magnetic material, and since an impedance of the weak magnetic material can be changed by a magnetic field, at least one of the first semiconductor layer, the second semiconductor layer and the conductive layer has a better impedance matching effect. Embodiments that at least one of the first semiconductor layer, the second semiconductor layer and the conductive layer of the magnetic light-emitting device contains the weak magnetic material are introduced below.

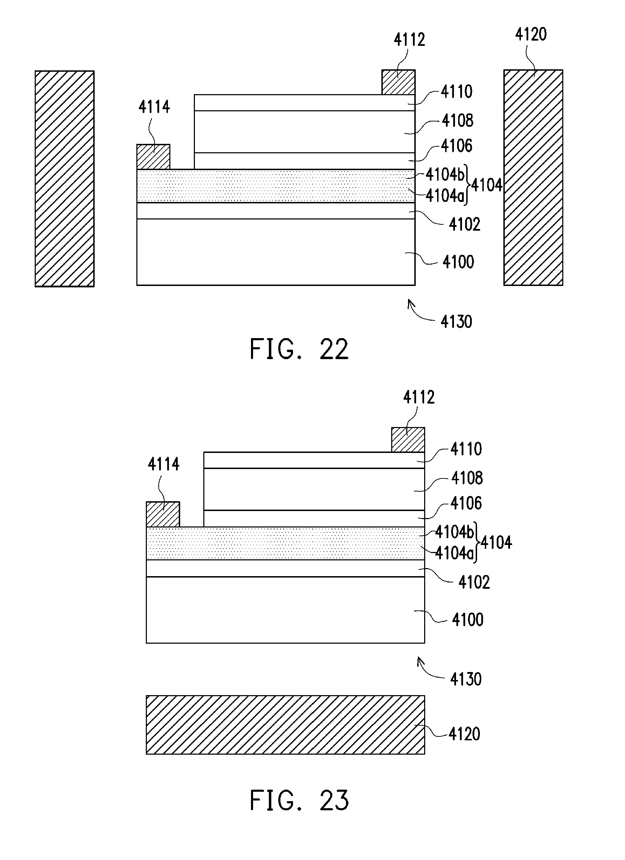

FIG. 22 is a schematic diagram of a magnetic light-emitting apparatus according to an embodiment of the disclosure. Referring to FIG. 22, the magnetic light-emitting apparatus of the embodiment includes a magnetic light-emitting device 4130 and a magnetic field generator 4120 located to at least one side of the magnetic light-emitting device 4130, which is, for example, a magnetic template.

The magnetic light-emitting device 4130 includes a submount 4100, a first semiconductor layer 4104, a light-emitting layer 4106, a second semiconductor layer 4108 and a conductive layer 4110. In an embodiment, the magnetic light-emitting device 4130 may further include a buffer layer 4102, a first electrode 4112 and a second electrode 4114.

A material of the submount 4100 can be a semiconductor or non-semiconductor material such as silicon, glass, gallium arsenide, gallium nitride, aluminum gallium arsenide, gallium phosphide, silicon carbide, indium phosphide, boron nitride, alumina or aluminum nitride, etc. Moreover, in an embodiment, the buffer layer 4102 further covers the submount 4100. A material of the buffer layer 4102 is, for example, gallium nitride or aluminium nitride. The buffer layer 4102 is not a necessary member of the light-emitting device. In other words, in other embodiments, fabrication of the buffer layer 4102 can be omitted.

The first semiconductor layer 4104 is disposed on the submount 4100. In the embodiment, a weak magnetic material is designed in the first semiconductor layer 4104 of the magnetic light-emitting device 4130. In detail, the first semiconductor layer 4104 includes a semiconductor material 4104a and a weak magnetic material 4104b doped in the semiconductor material 4104a. The semiconductor material 4104a of the first semiconductor layer 4104 is, for example, an N-type semiconductor material, which is, for example, a III-V compound semiconductor material doped with an N-type dopant, for example, gallium nitride, gallium arsenide or phosphorus gallium arsenide doped with the N-type dopant. Moreover, if the first semiconductor layer 4104 is formed through an epitaxy method, the first semiconductor layer 4104 is also referred to as an epitaxy layer. The weak magnetic material 4104b is doped in the semiconductor material 4104a. The weak magnetic material 4104b is, for example, manganese, etc. In an embodiment, the weak magnetic material 4104b is distributed at an upper portion of the semiconductor material 4104a. Namely, the weak magnetic material 4104b is set near the light-emitting layer 4106 and is adjacent to the light-emitting layer 4106. A method for setting the weak magnetic material 4104b near the light-emitting layer 4106 can be achieved by controlling processing parameters, which is described later. After the semiconductor material 4104a is doped with the weak magnetic material 4104b, an impedance of the formed first semiconductor layer 4104 becomes sensitive to a magnetic field variation.

The light-emitting layer 4106 is disposed on the first semiconductor layer 4104. The light-emitting layer 4106, for example, has a single or multiple quantum wells to improve the light-emitting efficiency. In an embodiment, the light-emitting layer 4106 has GaN/InGaN multiple quantum wells (MQW).

The second semiconductor layer 4108 is located on the light-emitting layer 4106. The second semiconductor layer 4108 is, for example, a P-type semiconductor layer, which includes a III-V compound semiconductor material doped with a P-type dopant, for example, gallium nitride, gallium arsenide or phosphorus gallium arsenide doped with the P-type dopant. Moreover, if the second semiconductor layer 4108 is formed through the epitaxy method, the second semiconductor layer 4108 is also referred to as an epitaxy layer.

It should be noticed that if the submount 4100 uses the III-V compound semiconductor material, the submount 4100 and the first semiconductor layer 4104, the second semiconductor layer 4108 and the light-emitting layer 4104 are homogeneous materials, and if the submount 4100 does not use the III-V compound semiconductor material, the submount 4100 and the first semiconductor layer 4104, the second semiconductor layer 4108 and the light-emitting layer 4104 are heterogeneous materials, and the submount 4100 is only used as a carrier.

The conductive layer 4110 covers the second semiconductor layer 4108, and is electrically connected to the first semiconductor layer 4104. In an embodiment, the conductive layer 4110 is a TCL. A material of the conductive layer 4110 can be a metal oxide, for example, indium tin oxide (ITO), cerium tin oxide (CTO), antimony tin oxide (ATO), indium zinc oxide (IZO) or zinc oxide (ZnO), etc. A thickness of the metal oxide is preferably smaller than 3500 Å. A material of the TCL 4110 can also be a stacked layer of metal thin layers, for example, a Ni/Au stacked layer. A thickness of the stacked layer of the metal thin layers is preferably smaller than 150 Å.

Moreover, in the embodiment, the magnetic light-emitting device 4130 further includes the first electrode 4112 and the second electrode 4114. The first electrode 4112 is located on the conductive layer 4110 and electrically connected to the conductive layer 4110. The second electrode 4114 is located on the exposed first semiconductor layer 4104 and electrically connected to the first semiconductor layer 4104.

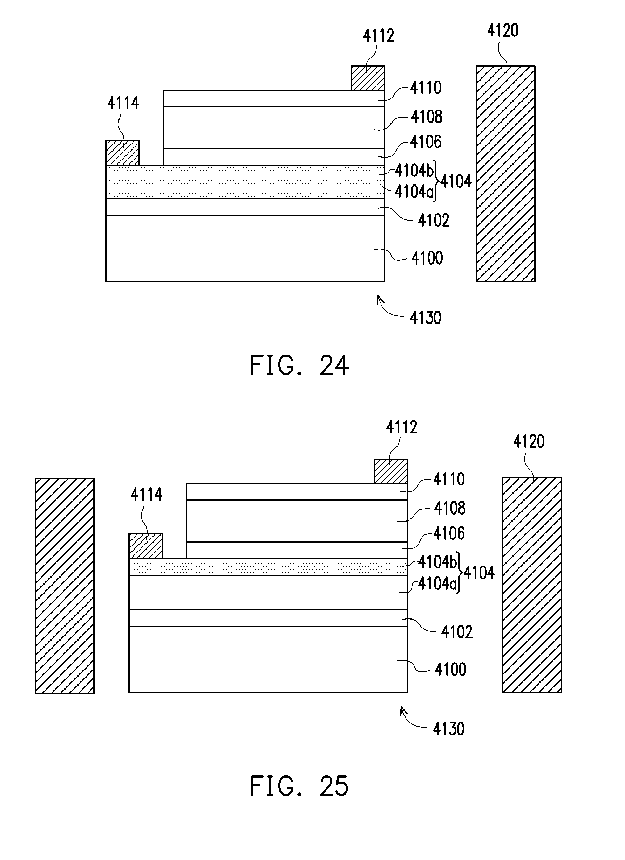

In addition, an intensity of a magnetic field generated by the magnetic field generator 4120 located to at least one side of the magnetic light-emitting device 4130 is, for example, higher than 0.01 gauss. Generally, the larger the generated magnetic field is, the larger the size of the magnetic field generator 4120 is. Under a premise of less space occupation, the size of the magnetic field generator 4120 is the smaller the better, though the magnetic field generator 4120 is still required to generate the magnetic field intensity of higher than 0.01 gauss in order to vary the impedance of the first semiconductor layer 4104 that has the weak magnetic material 4104b under the function of the magnetic field. In the embodiment, the magnetic field generator 4120 is located at two sides of the magnetic light-emitting device 4130, though the disclosure is not limited thereto. In other embodiments, the magnetic field generator 4120 can be disposed at only one side of the magnetic light-emitting device 4130, as that shown in FIG. 23 or FIG. 24. Preferably, a position of the magnetic field generator 4120 is as that shown in FIG. 22 or FIG. 23. Particularly, the magnetic field generator 4120 is preferably located at two sides of the magnetic light-emitting device 4130 (shown in FIG. 22). The magnetic field generator 4120 and the magnetic light-emitting device 4130 are arranged in a straight line, and the magnetic field generator 4120 and the magnetic light-emitting device 4130 are the closer the better.

In the embodiment, since the first semiconductor layer contains the weak magnetic material, and the weak magnetic material avails improving the impedance matching of the first semiconductor layer under the function of the magnetic field, the current distribution of the light-emitting device can be more even, so as to improve the photoelectric conversion efficiency of the light-emitting device.

In the above embodiment, the weak magnetic material in the first semiconductor layer is doped in the first semiconductor layer, though the disclosure is not limited thereto. In other embodiments, the weak magnetic material may exist in other forms. Referring to the embodiment of FIG. 25, the magnetic light-emitting apparatus of FIG. 25 is similar to the magnetic light-emitting apparatus of FIG. 22, and a difference there between is that the first semiconductor layer 4104 of FIG. 25 includes a semiconductor material 4104a and a weak magnetic material layer 4104b on the semiconductor material 4104a. In other words, in the present embodiment, the weak magnetic material layer 4104b covers the surface of the semiconductor material 4104a in form of a film layer. Therefore, the weak magnetic material layer 4014b is disposed between the semiconductor material 4104a and the light-emitting layer 4106.

In the aforementioned embodiments, the weak magnetic materials are all designed in the first semiconductor layers, though the disclosure is not limited thereto. In other embodiments, the weak magnetic material can also be designed in the second semiconductor layer to adjust the impedance matching of the conductive layer under the function of the magnetic field.

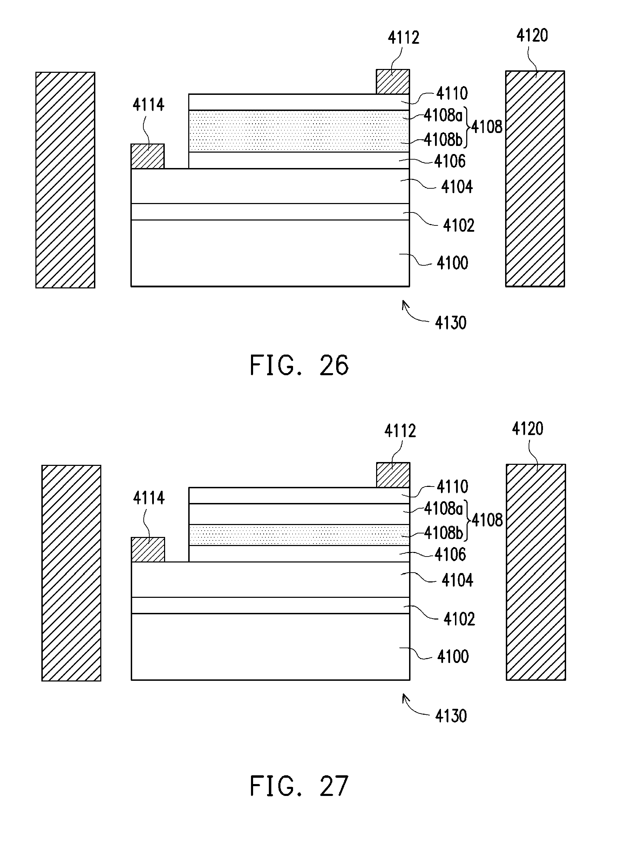

Referring to FIG. 26, the magnetic light-emitting apparatus of FIG. 26 is similar to the magnetic light-emitting apparatus of FIG. 22, and a difference there between is that the first semiconductor layer 4104 of FIG. 26 is a III-V compound semiconductor material simply doped with an N-type dopant, and the second semiconductor layer 4108 includes a semiconductor material 4108a and a weak magnetic material 4108b doped in the semiconductor material 4108a. The weak magnetic material 4108b is, for example, manganese. In an embodiment, the weak magnetic material 4108b is distributed at a lower portion of the semiconductor material 4108a. Namely, the weak magnetic material 4108b is set near the active layer 4106 and is adjacent to the active layer 4106. A method for setting the weak magnetic material 4108b near the active layer 4106 can be achieved by controlling processing parameters, which is described later. After the semiconductor material 4108a is doped with the weak magnetic material 4108b, an impedance of the formed second semiconductor layer 4108 becomes sensitive to the magnetic field variation.

According to another embodiment, referring to FIG. 27, the magnetic light-emitting apparatus of the embodiment of FIG. 27 is similar to the magnetic light-emitting apparatus of FIG. 26, and a difference there between is that the second semiconductor layer 4108 of FIG. 27 includes the semiconductor material 4108a and a weak magnetic material layer 4108b under the semiconductor material 4108a. Therefore, the weak magnetic material layer 4108b is disposed between the semiconductor material 4108a and the active layer 4106.

In the aforementioned embodiments, the weak magnetic material is designed in the first semiconductor layer or the second semiconductor layer, though the disclosure is not limited thereto. In other embodiments, the weak magnetic material can also be designed in the conductive layer to adjust the impedance matching of the conductive layer under the function of the magnetic field.

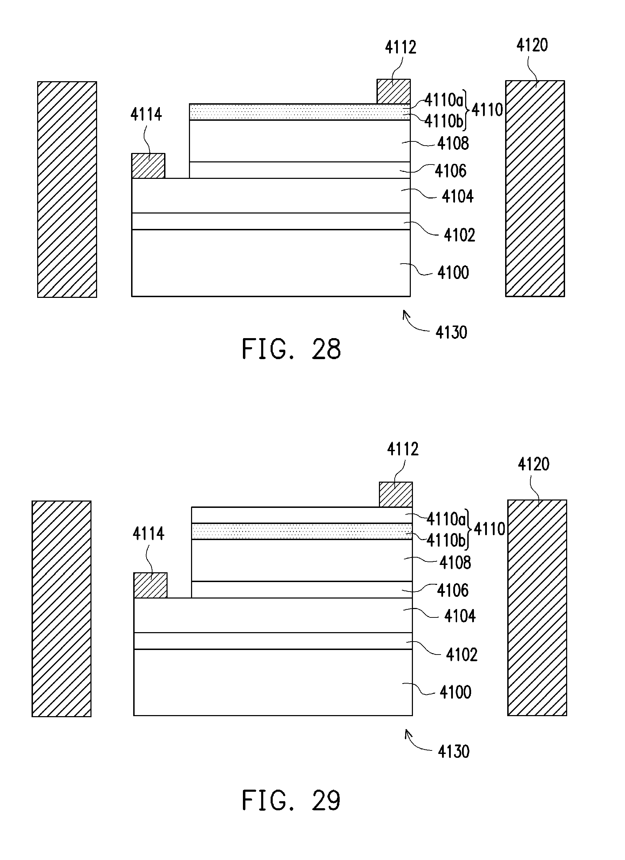

Referring to FIG. 28, the magnetic light-emitting apparatus of the embodiment of FIG. 28 is similar to the magnetic light-emitting apparatus of FIG. 22, and a difference there between is that the first semiconductor layer 4104 of FIG. 28 is a III-V compound semiconductor material simply doped with an N-type dopant. The conductive layer 4110 includes a conductive material 4110a and a weak magnetic material 4110b doped in the conductive material 4110a. The weak magnetic material 4110b is, for example, manganese. In an embodiment, the weak magnetic material 4110b is distributed at a lower portion of the conductive material 4110a. Namely, the weak magnetic material 4110b is set near the second semiconductor layer 4108 and is adjacent to the second semiconductor layer 4108. A method for setting the weak magnetic material 4110b near the second semiconductor layer 4108 can be achieved by controlling processing parameters, which is described later. After the conductive material 4110a is doped with the weak magnetic material 4110b, an impedance of the formed conductive layer 4110 becomes sensitive to the magnetic field variation.

According to another embodiment, referring to FIG. 29, the magnetic light-emitting apparatus of the embodiment of FIG. 29 is similar to the magnetic light-emitting apparatus of FIG. 28, and a difference there between is that the conductive layer 4110 of FIG. 29 includes a conductive material 4110a and a weak magnetic material layer 4110b under the conductive layer 4110a. Therefore, the weak magnetic material layer 4110b is disposed between the conductive material 4110a and the second semiconductor layer 4108.

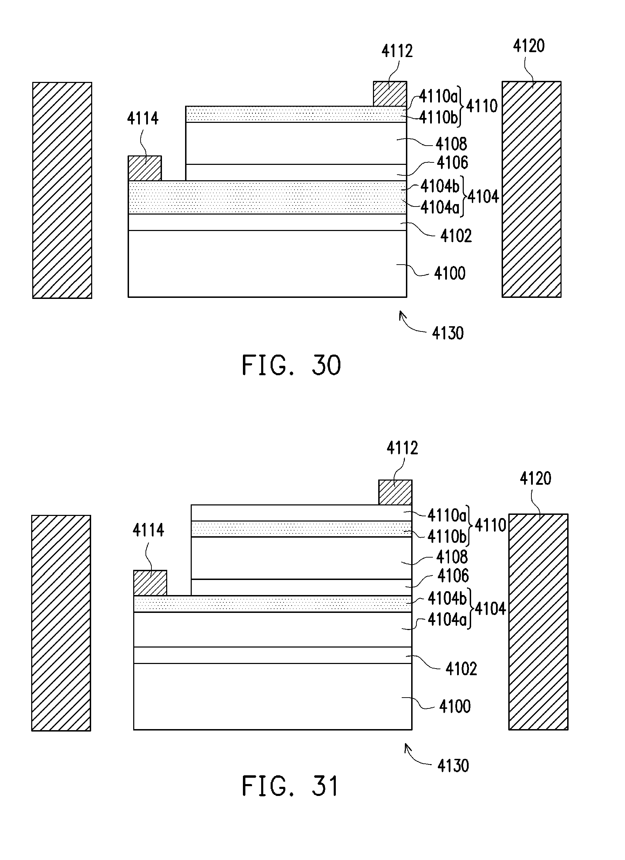

In the aforementioned embodiments, the weak magnetic material is designed in the first semiconductor layer 4104, the second semiconductor layer 4108 or the conductive layer 4110, though the disclosure is not limited thereto. In other embodiments, the weak magnetic material can also be designed in two of or all of the first semiconductor layer 4104, the second semiconductor layer 4108 and the conductive layer 4110. A situation that the weak magnetic material is designed in the first semiconductor layer 4104 and the conductive layer 4110 is taken as an example for descriptions. Referring to FIG. 30, the magnetic light-emitting apparatus of the embodiment of FIG. 30 is similar to the magnetic light-emitting apparatus of FIG. 22, and a difference there between is that in the embodiment of FIG. 30, besides that the first semiconductor layer 4104 is composed of the semiconductor material 4104a and the weak magnetic material 4104b doped in the semiconductor material 4104a, the conductive layer 4110 is composed of the conductive material 4110a and the weak magnetic material 4110b doped in the conductive material 4110a. According to another embodiment, referring to FIG. 31, the magnetic light-emitting apparatus of the embodiment of FIG. 31 is similar to the magnetic light-emitting apparatus of FIG. 25, and a difference there between is that in the embodiment of FIG. 31, besides that the first semiconductor layer 4104 is composed of the semiconductor material 4104a and the weak magnetic material layer 4104b disposed on the semiconductor material 4104a, the conductive layer 4110 is composed of the conductive material 4110a and the weak magnetic material layer 4110b disposed under the conductive material 4110a.

It should be noticed that in the aforementioned embodiments, if the submount 4100 is composed of a non-transparent material and the conductive layer 4110 is a TCL, the magnetic light-emitting device 4130 is a single-side light-emitting type (an upward lighting type) light-emitting device. Moreover, if the submount 4100 is composed of a transparent material and the conductive layer 4110 is a non-transparent conductive layer, the magnetic light-emitting device 4130 is a single-side light-emitting type (a downward lighting type) light-emitting device. In addition, if the submount 4100 is composed of a transparent material and the conductive layer 4110 is a TCL, the magnetic light-emitting device 4130 is a double-side light-emitting type light-emitting device.

Moreover, in the aforementioned embodiments, the horizontal electrode type magnetic light-emitting device is taken as an example for descriptions. Actually, the characteristic that the weak magnetic material is designed in at least one of the first semiconductor layer, the second semiconductor layer and the conductive layer of the disclosure can also be applied to vertical electrode type magnetic light-emitting devices, flip-chip type light-emitting devices or other types of the light-emitting device.

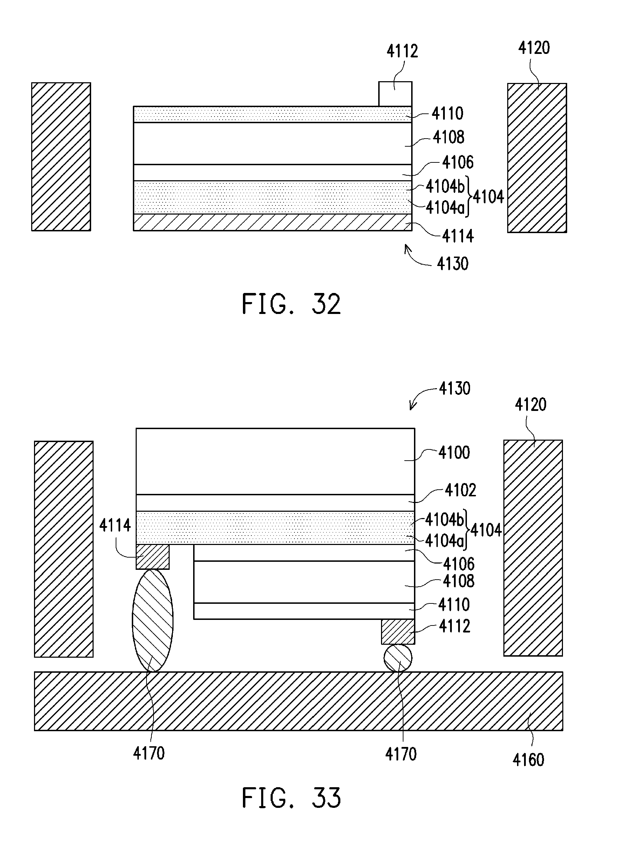

FIG. 32 is a schematic diagram of a vertical electrode type magnetic light-emitting device according to an embodiment of the disclosure. Referring to FIG. 32, which illustrates a structure similar to that of FIG. 22, and a difference there between is that the second electrode 4114 is disposed at the back of the first semiconductor layer 4104, so that the first semiconductor layer 4104, the light-emitting layer 4106, the second semiconductor layer 4108 and the conductive layer 4110 are included between the first electrode 4112 and the second electrode 4114. Particularly, in the vertical electrode type magnetic light-emitting device of FIG. 32, the first semiconductor layer 4104 is doped with the weak magnetic material 4104b. However, the structures of FIG. 23 and FIG. 31 can also be applied in the vertical electrode type magnetic light-emitting device.

FIG. 33 is a schematic diagram of a flip-chip type magnetic light-emitting device according to an embodiment of the disclosure. Referring to FIG. 33, which illustrates a structure similar to that of FIG. 22, and a difference there between is that the magnetic light-emitting device of the embodiment further includes a circuit board 4160 and a conductive material 4170. In other words, the light-emitting device 4130 of FIG. 22 is turned over by 180 degrees and disposed on the circuit board 4160, and the first electrode 4112 and the second electrode 4114 are electrically connected to the circuit board 4160 through the conductive material 4170. Particularly, in the flip-chip type magnetic light-emitting device of FIG. 33, the first semiconductor layer 4104 is doped with the weak magnetic material 4104b. However, the structures of FIG. 23 and FIG. 31 can also be applied in the flip-chip type magnetic light-emitting device.

A plurality of embodiments is provided below to describe methods for fabricating the magnetic light-emitting devices of the aforementioned embodiments.

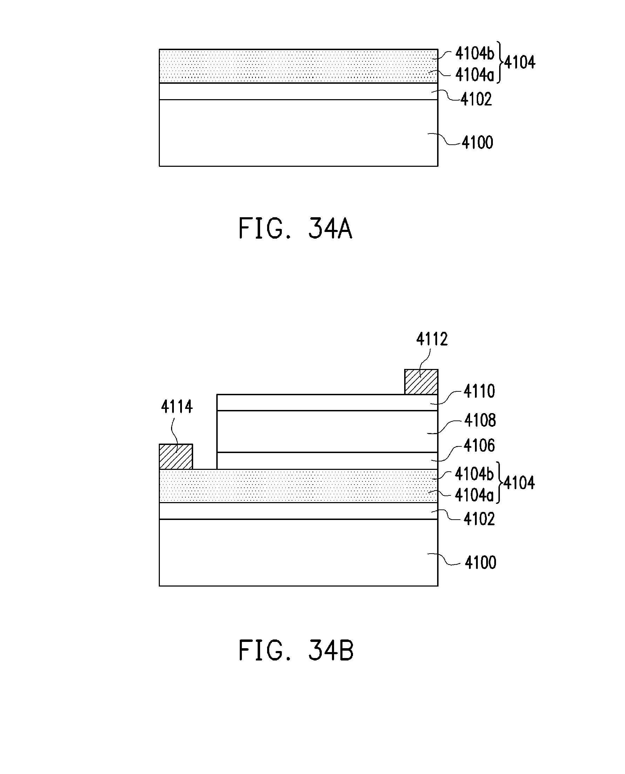

FIG. 34A to FIG. 34B are schematic diagrams illustrating a fabrication flow of a magnetic light-emitting device according to an embodiment of the disclosure. Referring to FIG. 34A, an insulation layer 4102 is first formed on the submount 4100, and then the first semiconductor layer 4104 is formed on the insulation layer 4102. In an embodiment, a method of forming the first semiconductor layer 4104 is to use an epitaxy process, and meanwhile the weak magnetic material is added during the epitaxy process, so that while epitaxial growth of the semiconductor material 4104a on the submount 4100 is implemented, doping of the weak magnetic material is simultaneously implemented during the epitaxy process. In this way, the semiconductor material 4104a is doped with the weak magnetic material 4104b. According to another embodiment, a method of forming the first semiconductor layer 4104 is to first use the epitaxy process to implement epitaxial growth of the semiconductor material 4104a on the submount 4100, and then a weak magnetic material doping layer (not shown) is formed on the epitaxial semiconductor material 4104a. Then, a tempering process is performed to spread the dopant in the weak magnetic material doping layer to the epitaxial semiconductor material 4104a, so as to dope the weak magnetic material 4104b in the semiconductor material 4104a. By controlling a time and a temperature of the tempering process, the weak magnetic material 4104b can be distributed to an upper portion of the semiconductor material 4104a. According to another embodiment, a method of forming the first semiconductor layer 4104 is to first use the epitaxy process to implement epitaxial growth of the semiconductor material 4104a on the submount 4100, and then an ion implantation process is performed to implant the weak magnetic material 4104b into the semiconductor material 4104a. By controlling parameters of the ion implantation process, the weak magnetic material 4104b can be distributed to the upper portion of the semiconductor material 4104a. After fabrication of the first semiconductor layer 4104 of FIG. 34A is completed, as shown in FIG. 34B, the light-emitting layer 4106, the second semiconductor layer 4108, the conductive layer 4110 and the first and the second electrodes 4112 and 4114 are sequentially formed.

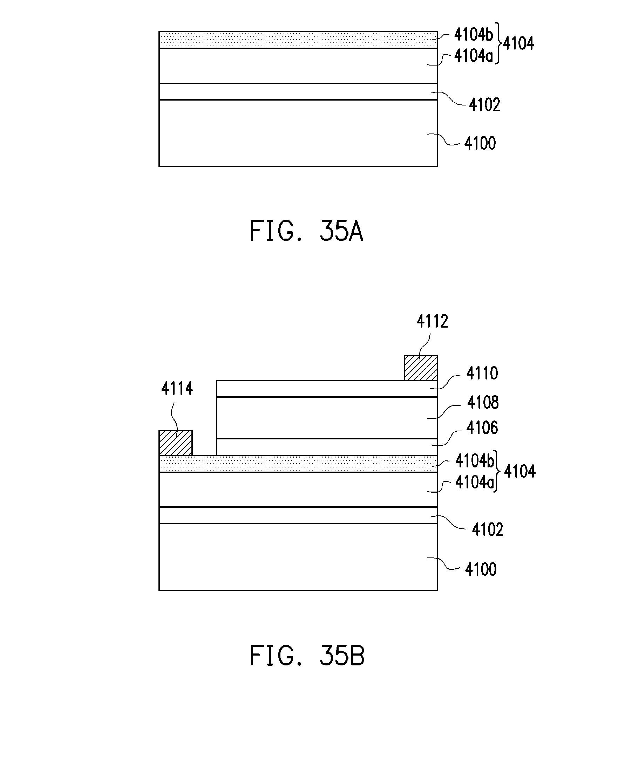

FIG. 35A to FIG. 35B are schematic diagrams illustrating a fabrication flow of a magnetic light-emitting device according to an embodiment of the disclosure. Referring to FIG. 35A, after the insulation layer 4102 is first formed on the submount 4100, the epitaxy process is used to implement epitaxial growth of the semiconductor material 4104a on the submount 4100, and then the weak magnetic material layer 4104b is formed on the epitaxial semiconductor material 4104a to form the first semiconductor layer 4104. The weak magnetic material layer 4104b can be formed by using the epitaxy process or a deposition process. After fabrication of the first semiconductor layer 4104 of FIG. 35A is completed, as shown in FIG. 35B, the light-emitting layer 4106, the second semiconductor layer 4108, the conductive layer 4110 and the first and the second electrodes 4112 and 4114 are sequentially formed.

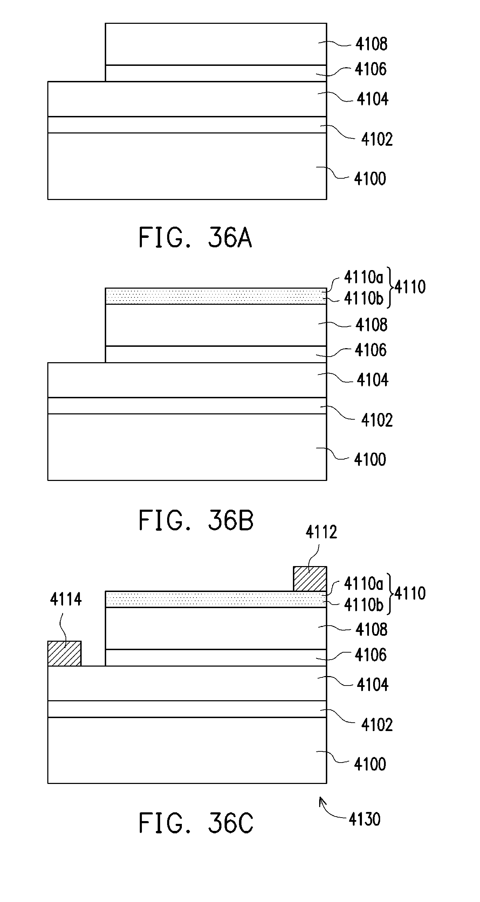

FIG. 36A to FIG. 36C are schematic diagrams illustrating a fabrication flow of a magnetic light-emitting device according to an embodiment of the disclosure. Referring to FIG. 36A, the insulation layer 4102, the first semiconductor layer 4104, the light-emitting layer 4106 and the second semiconductor layer 4108 are sequentially formed on the submount 4100. Then, as shown in FIG. 36B, a conductive layer 4110 is formed on the second semiconductor layer 4108. The conductive layer 4110 is, for example, formed through a deposition process or a coating process, and the weak magnetic material is added to the aforementioned process to implement doping of the weak magnetic material during the deposition process or the coating process that is used to form the conductive material 4110a. In this way, the conductive material 4110a is doped with the weak magnetic material 4110b. According to another embodiment, a method of forming the conductive layer 4110 is to first use the deposition process or the coating process to form the conductive material 4110a, and then a weak magnetic material doping layer (not shown) is formed on the conductive material 4110a. Then, a tempering process is performed to spread the dopant in the weak magnetic material doping layer to the conductive material 4110a, so as to dope the weak magnetic material 4110b in the conductive material 4110a. By controlling a time and a temperature of the tempering process, the weak magnetic material 4110b can be distributed to a lower portion of the conductive material 4110a. According to another embodiment, a method of forming the conductive layer 4110 is to first use the deposition process or the coating process to form the conductive material 4110a, and then an ion implantation process is performed to implant the weak magnetic material 4110b into the conductive material 4110a. By controlling parameters of the ion implantation process, the weak magnetic material 4104b can be distributed to the lower portion of the conductive material 4110a. After fabrication of the conductive layer 4110 of FIG. 35B is completed, as shown in FIG. 34C, the first electrode 4112 and the second electrode 4114 are sequentially formed.

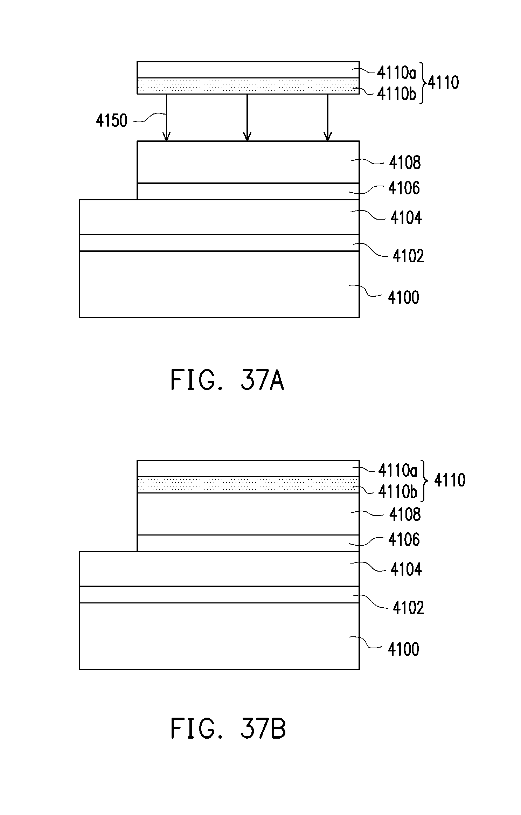

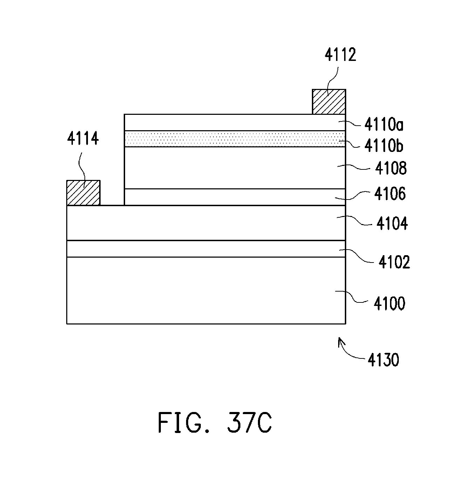

FIG. 37A to FIG. 37C are schematic diagrams illustrating a fabrication flow of a magnetic light-emitting device according to an embodiment of the disclosure. Referring to FIG. 37A, the insulation layer 4102, the first semiconductor layer 4104, the light-emitting layer 4106 and the second semiconductor layer 4108 are sequentially formed on the submount 4100. Moreover, the weak magnetic material layer 4110b is formed on the conductive material 4110a. Then, a bonding process 4150 is performed to bond the conductive layer 4110 to the second semiconductor layer 4108 located on the submount 4100, so as to form a structure shown in FIG. 37B. Then, as shown in FIG. 37C, the first electrode 4112 and the second electrode 4114 are sequentially formed.

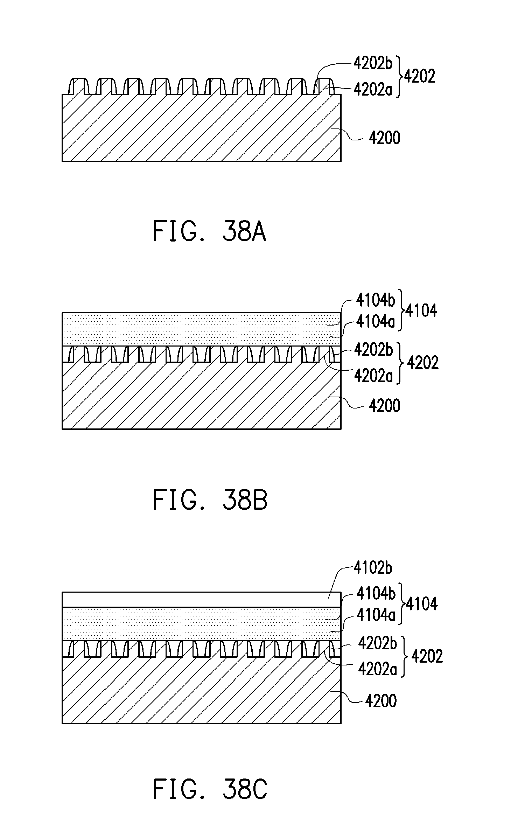

FIG. 38A to FIG. 38G are schematic diagrams illustrating a fabrication flow of a magnetic light-emitting device according to an embodiment of the disclosure. Referring to FIG. 38A, a carrier 4200 is first provided, and a nano-rod layer 4202 is formed on the carrier 4200. Particularly, the nano-rod layer 4202 includes a plurality of nano-rods 4202a and a protection layer 4202b covering side surfaces of the nano-rods 4202a. A material of the protection layer 4202b can be a dielectric material, for example, silicon oxide or silicon nitride. A material of the carrier 4200 is, for example, gallium nitride, and a height of the nano-rod layer 4202 is about 1 micron ($\mu$).

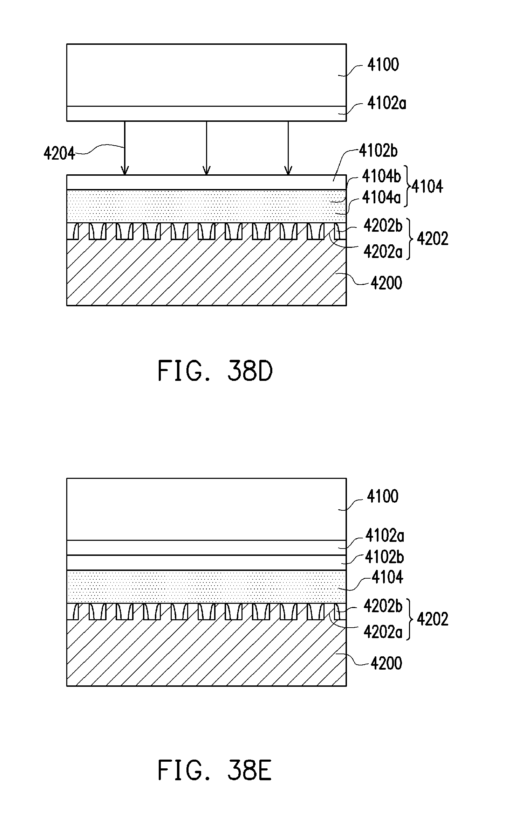

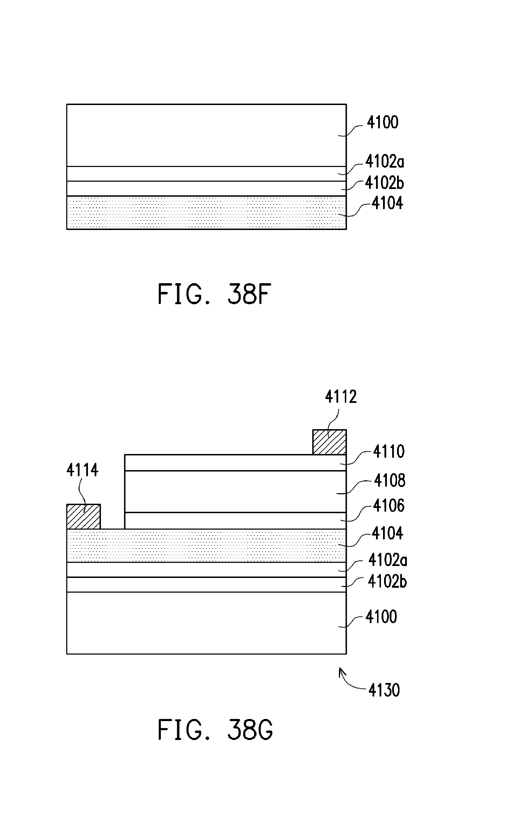

Then, referring to FIG. 38B, a plasma assisted metal organic chemical vapor deposition (PA-MOCVD) process is used to form the first semiconductor layer 4104 on the nano-rod layer 4202, where the first semiconductor layer 4104 includes the semiconductor material 4104a and the weak magnetic material 4104b doped in the semiconductor material 4104a. Then, as shown in FIG. 38C, a bonding layer 4102b is formed on the first semiconductor layer 4104, and a material of the bonding layer 4102b is, for example, silicon oxide. Then, referring to FIG. 38D, a submount 4100 is provided, where an insulation layer 4102a is formed on the submount 4100, and the insulation layer 4102a may serve as a bonding layer. Then, a bonding process 4204 is performed to bond the bonding layer 4102a on the submount 4100 with the bonding layer 4102b on the carrier 4200, so as to form a structure shown in FIG. 38E. Then, a cooling process is performed, and since thermal expansion coefficients of the submount 4100 and the carrier 4200 are different, a stress of the whole structure is released at the most vulnerable nano-rod layer 4202, so that the carrier 4200 is separated from such place to form a structure shown in FIG. 38F, and the structure of FIG. 38F is also referred to as a template. Then, referring to FIG. 38G, the light-emitting layer 4106, the second semiconductor layer 4108, the conductive layer 4110 and the first and the second electrodes 4112 and 4114 are sequentially formed on the first semiconductor layer 4104.

The aforementioned several fabrication methods are only used to convey the spirit of the fabrication method of the magnetic light-emitting device of the disclosure to those skilled in the art, which are not used to limit the disclosure.

In conclusion, since at least one of the first semiconductor layer, the second semiconductor layer and the conductive layer includes the weak magnetic material, under the function of the magnetic field, the weak magnetic material can mitigate the problem of impedance mismatching of at least one of the first semiconductor layer, the second semiconductor layer and the conductive layer, so as to even the current distribution of the light-emitting device and improve the photoelectric conversion efficiency of the light-emitting device.

A Hall effect under the magnetic field is further considered, and the Hall effect is applied in the light-emitting device.

It should be noticed that the following embodiments are described more fully with reference to the accompanying drawings, in which exemplary embodiments of the disclosure are shown. The terms used herein such as "above", "below", "front", "back", "left", "right", "inside" and "outside" are for the purpose of describing directions in the figures only and are not intended to be limiting of the disclosure.

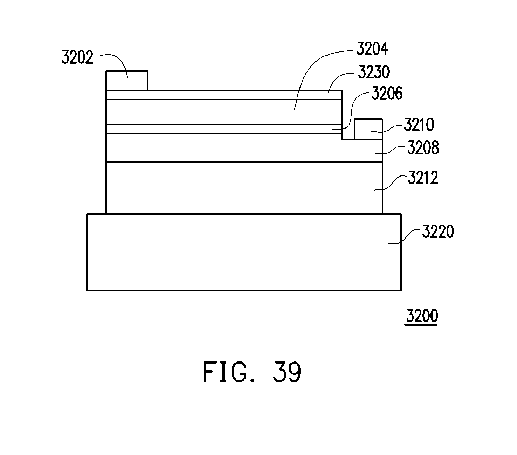

Taking a standard LED having a horizontal structure as an example, FIG. 39 is a cross-sectional view of a light-emitting device according to an embodiment of the disclosure. Referring to FIG. 39, the light-emitting device 3200 is a horizontal LED, which includes a light-emitting structure coupled to a magnetic material. In an embodiment, the light-emitting device can be disposed on a magnetic submount 3220 through epoxy, metal bonding, wafer bonding, epitaxy embedding and coating, etc. The magnetic submount 3220 is, for example, a ferromagnetic layer magnetized along a required direction.

The light-emitting structure includes a first electrode 3202, a first doped layer 3204, an active layer 3206, a second doped layer 3208, a second electrode 3210 and a substrate 3212. The first doped layer 3204 is, for example, a P-type doped layer, and the second doped layer 3208 is, for example, an N-type doped layer. The substrate 3212 is disposed on the magnetic submount 3220. The first doped layer 3204, the active layer 3206 and the second doped layer 3208 are disposed on the substrate 3212 to commonly form a light-emitting stacking layer. The first electrode 3202 is disposed on the first doped layer 3204, and is electrically connected to the first doped layer 3204. The second electrode 3210 and the first electrode 3202 are disposed at a same side, and the second electrode 3210 is electrically connected to the second doped layer 3208 to form a horizontal LED structure. The active layer 3206 is disposed between the first doped layer 3204 and the second doped layer 3208, and can produce light to serve as a light-emitting layer when a current flows there through. In an embodiment, the light-emitting structure further includes a TCL 3230, which is disposed on top of the first doped layer 3204 to enhance current distribution evenness. A material of the TCL 3230 is, for example, metal or semiconductor.

Then, the light-emitting device of the embodiment is further described with reference of top-view figures. It should be noticed that electrode configurations of the horizontal LED are introduced in detail below, which are only used as an example, and are not used to limit the disclosure. Certainly, a shape and a number of the electrodes are not specifically restricted. Moreover, in the following embodiment, a conductive type of the first doped region is P-type, and a conductive type of the second doped region is N-type, though the disclosure is not limited thereto. Those skilled in the art should understand that the conductive type of the first doped region can be the N-type, and the conductive type of the second doped region can be the P-type.

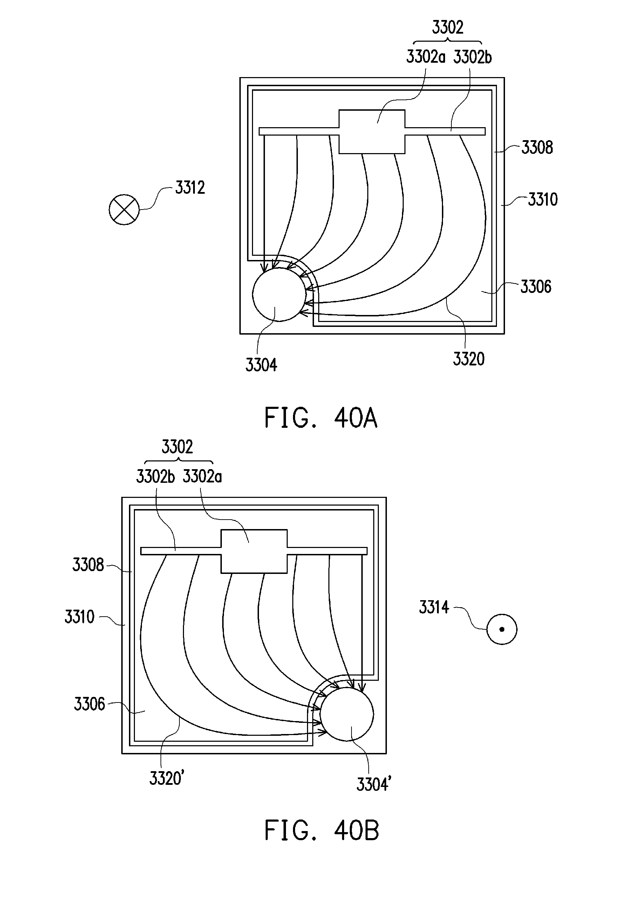

FIG. 40A to FIG. 40C are top views of a light-emitting device according to an embodiment of the disclosure. Like reference numerals in FIG. 40A to FIG. 40C denote like elements, and thus their descriptions are omitted.

Referring to FIG. 40A, the light-emitting device having the magnetic field includes a first electrode 3302 and a second electrode 3304 disposed at the same side. The first electrode 3302 is disposed on a TCL 3306, and the first electrode 3302 is electrically connected to a first doped layer 3308. The first doped layer 3308 is, for example, the P-type doped layer. In an embodiment, the first electrode 3302 includes a pad 3302a and two finger portions 3302b, where the finger portions 3302b are connected to the pad 3302a. The finger portions 3302b have a straight bar-shape, and respectively extend outwards from two opposite sides of the pad 3302a. The finger structure is also referred to as a set of parallel outlines according to general characteristics. The second electrode 3304 is disposed on a second doped layer 3310, and is electrically connected to the second doped layer 3310. The second doped layer 3310 is, for example, the N-type doped layer.

In the light-emitting device, the first electrode 3302 and the second electrode 3304 are, for example, configured in an asymmetric manner. In detail, configuration positions of the pad 3302a of the first electrode 3302 and the second electrode 3304 are not symmetric to a center point of the light-emitting device, so that spaces between various parts of the first electrode 3302 and various parts of the second electrode 3304 are not completely the same. In an embodiment, the second electrode 3304 is disposed at a corner to the left.

According to the above descriptions, the light-emitting device includes a magnetic material capable of providing a magnetic field, and a direction 3312 of the provided magnetic field is a direction pointing to a paper surface (shown in FIG. 40A). In this way, when a voltage is applied to the first electrode 3302 and the second electrode 3304, a current 3320 flowing from the first electrode 3302 to the second electrode 3304 is shifted rightwards under the function of the Lorenz's force.

In detail, in case an external magnetic field is not applied, since the first electrode 3302 and the second electrode 3304 are configured in the asymmetric manner, the current is mainly distributed on a shorter path to the left between the first electrode 3302 and the second electrode 3304, which may cause an uneven current distribution to decrease the light-emitting efficiency. However, after the external magnetic field having the magnetic field direction 3312 is applied, even if the configuration positions of the first electrode 3302 and the second electrode 3304 are asymmetric, the current 3320 is shifted rightwards under the function of the magnetic field, so that the current 3320 originally gathered at the left side of the light-emitting device is now distributed to the right side. Therefore, by applying the external magnetic field to the light-emitting device, the current 3320 can be shifted to achieve an even distribution effect, so as to improve the light-emitting efficiency.

Referring to FIG. 40B, in an embodiment, when the second electrode 3304' is disposed at the corner to the right, the magnetic field direction 3314 provided by the external magnetic field has to be accordingly adjusted in order to evenly distribute the current 3320'. The magnetic field direction 3314 is, for example, a direction pointing out from the paper surface (shown in FIG. 40B). In case that the external magnetic field is not applied, the current is mainly gathered at the right side. After the external magnetic field having the magnetic field direction 3314 is applied, a current 3320' flowing from the first electrode 3302 to the second electrode 3304 is shifted lefttwards under the function of the Lorenz's force, so that the current 3320' can be evenly distributed in a large area, so as to improve the light-emitting efficiency.

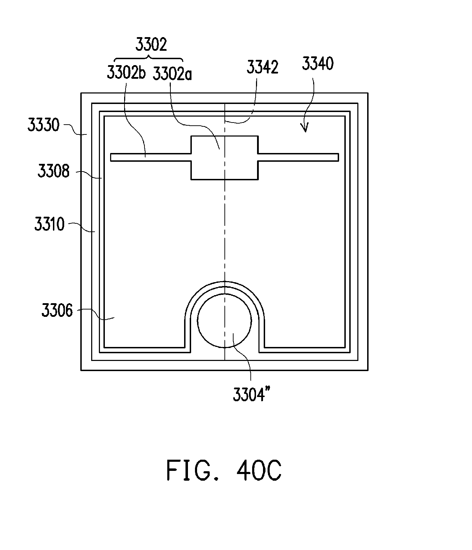

Referring to FIG. 40C, in an embodiment, when the second electrode 3304" is disposed at a lower side in the middle, the light-emitting efficiency can be improved by applying the external magnetic field. In detail, a connection line of a geometric center of the first electrode 3302 and a geometric center of the second electrode 3304" substantially bisects a top surface 3340 of the light-emitting structure. Namely, although spaces between various parts of the first electrode 3302 and various parts of the second electrode 3304" are not completely the same, the light-emitting device shown in FIG. 40C is symmetrically configured along the connection line of the first electrode 3302 and the second electrode 3304". Moreover, a symmetric centerline 3342 substantially bisects an area of the top surface 3340 equally, and the symmetric centerline 3342 passes through the pad of the second electrode 3304". In the embodiment, even if the geometric center of the first electrode 3302 and the geometric center of the second electrode 3304" are disposed in a symmetric manner, by adjusting the thickness of the TCL 3306 according to a magnetoresistance effect caused by the magnetic field, the impedance matching can be easily implemented, so as to improve the light-emitting efficiency of the light-emitting device.

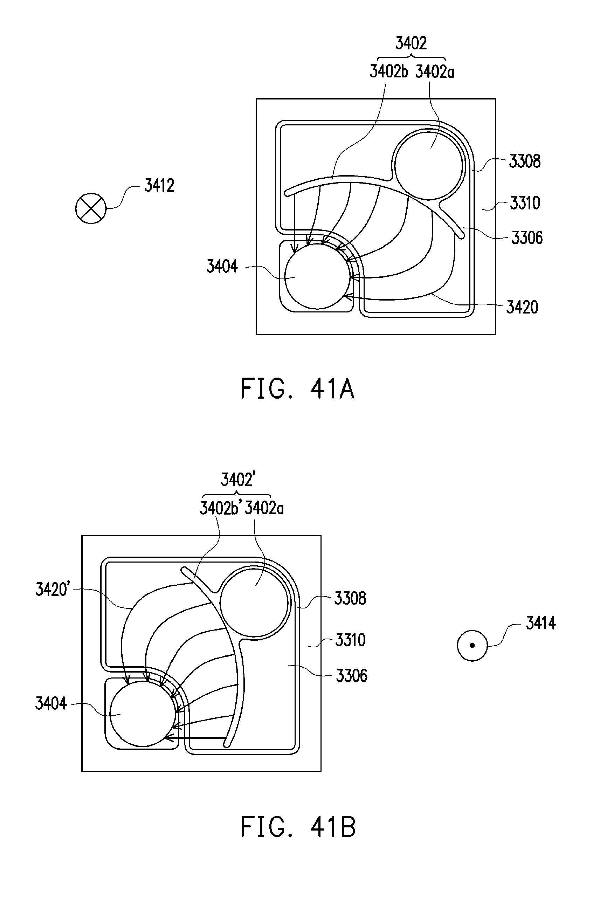

FIG. 41A to FIG. 41C are top views of a light-emitting device according to another embodiment of the disclosure. In FIG. 41A to FIG. 41B, elements the same to that in FIG. 40A are indicated by the same referential numbers, and their descriptions are omitted.

Referring to FIG. 41A, the first electrode 3402 is disposed on the TCL 3306, and the first electrode 3402 is electrically connected to the first doped layer 3308. In an embodiment, the first electrode 3402 includes a pad 3402a and a finger portion 3402b, where the finger portion 3402b is connected to the pad 3402a. The finger portion 3402b, for example, has an arc-shape, and extends from two sides of the pad 3402a. The second electrode 3404 is disposed on the second doped layer 3310, and is electrically connected to the second doped layer 3310.

The first electrode 3402 and the second electrode 3404 are, for example, configured in an asymmetric manner, so that spaces between various parts of the first electrode 3402 and various parts of the second electrode 3404 are not completely the same. In an embodiment, the pad 3402a of the first electrode 3402 and the second electrode 3404 are respectively disposed on a diagonal of the light-emitting device, and the finger portion 3402b of the first electrode 3402 is close to the second electrode 3404 at the upper left part.

As describe above, in case that the external magnetic field is not applied, the current is mainly distributed on a shorter path to the upper left between the first electrode 3402 and the second electrode 3404, which may cause an uneven current distribution to decrease the light-emitting efficiency. Therefore, after the magnetic field with the magnetic field direction 3412 pointing to the paper surface (shown in FIG. 40A) is provided, the current 3420 flowing from the first electrode 3402 to the second electrode 3404 is shifted to the lower right under the function of the Lorenz's force, so that the current 3420 can be evenly distributed to various regions of the light-emitting device.

Referring to FIG. 41B, in an embodiment, when the finger portion 3402b' of the first electrode 3402' is close to the second electrode 3404 at the lower right part, the magnetic field direction 3414 provided by the external magnetic field has to be accordingly adjusted in order to evenly distribute the current 3420'. The magnetic field direction 3314 is, for example, a direction pointing out from the paper surface (shown in FIG. 41B). In case that the external magnetic field is not applied, the current is mainly gathered at the position closer to the lower right. After the external magnetic field having the magnetic field direction 3414 is applied, a current 3420' flowing from the first electrode 3402' to the second electrode 3404 is shifted to the upper left under the function of the Lorenz's force, so that the current 3420' can be evenly distributed in a large area, so as to improve the light-emitting efficiency.

In the embodiment of FIG. 41A and FIG. 41B, the finger portion 3402b of the first electrode 3402 and the finger portion 3402b' of the first electrode 3402' do not respectively have a symmetric centerline, though the disclosure is not limited thereto.

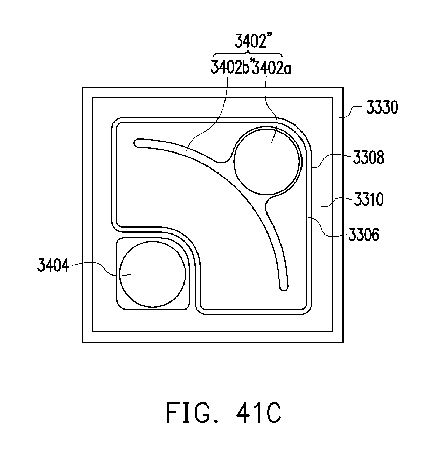

Referring to FIG. 41C, the finger portion 3402b" of the first electrode 3402" has a symmetric centerline 3442. A structural portion of the finger portion 3402b" corresponding to the symmetric centerline 3442 has a symmetric structure extending towards two sides. In an embodiment, the symmetric centerline 3442 substantially bisects an area of a top surface 3440 equally, and the symmetric centerline 3442 passes through the connection pad of the second electrode 3404. In an embodiment, when the finger portion 3402b" of the first electrode 3402" is connected to the connection pad 3402a in a symmetric manner, the external magnetic field can also be applied to improve the light-emitting efficiency. In detail, the finger portion 3402b" is symmetrically disposed at two sides of the connection pad 3402a, and a connection line of a geometric center of the first electrode 3402" and a geometric center of the second electrode 3404 substantially bisects the light-emitting structure. Namely, although spaces between various parts of the first electrode 3402" and various parts of the second electrode 3404 are not completely the same, the light-emitting device shown in FIG. 41C is symmetrically configured along the connection line of the first electrode 3402' and the second electrode 3404. In the embodiment, even if the geometric center of the first electrode 3402" and the geometric center of the second electrode 3404 are disposed in the symmetric manner, by adjusting the thickness of the TCL 3306 according to a magnetoresistance effect caused by the magnetic field, the impedance matching can be easily implemented, so as to improve the light-emitting efficiency of the light-emitting device.

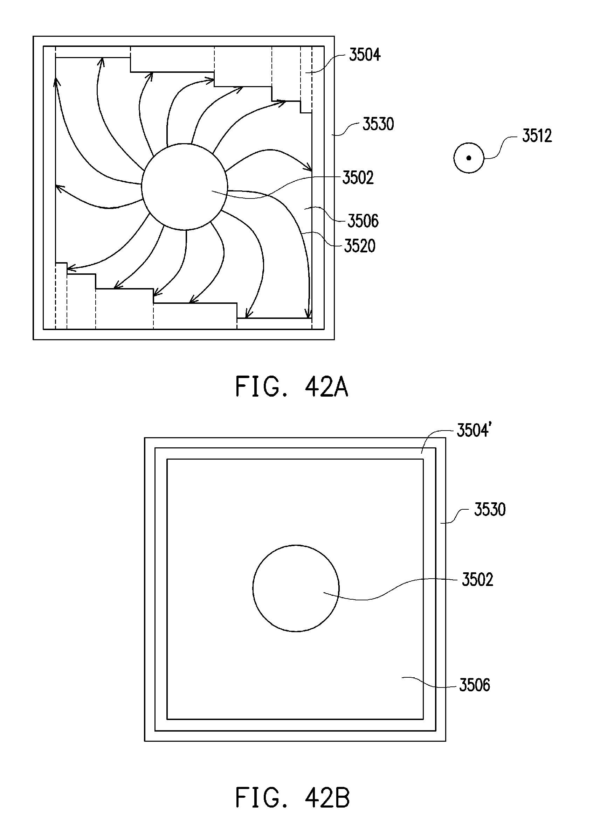

FIG. 42A to FIG. 42C are top views of a light-emitting device according to another embodiment of the disclosure. For simplicity's sake, only electrode distribution configurations of the light-emitting device are illustrated in FIGs. 42A-42C.

It should be noticed that for simplicity's sake, electrode distribution configurations are mainly illustrated in FIGs. 42A-42C, and configuration positions of other components can be implemented and varied according to the techniques known by those skilled in the art.

Referring to FIG. 42A, in the embodiment, the light-emitting device is a horizontal LED, which includes a light-emitting structure and a magnetic submount 3530. The light-emitting device having the magnetic field at least includes a first electrode structure 3502 and a second electrode structure 3504 that are disposed at the same side and a TCL 3506, where the first electrode structure 3502 is disposed on the TCL 3506. The first electrode structure 3502 is, for example, disposed in a central area of the light-emitting device, and the second electrode structure 3504 is, for example, disposed at an outer edge area of the light-emitting device. Namely, the second electrode structure 3504 is, for example, a ring-shape structure, which is disposed at peripheral of the first electrode structure 3502. In an embodiment, the second electrode structure 3504 includes a second electrode. As shown in FIG. 42A, a shape of the second electrode is an asymmetric irregular polygon, which is, for example, a pattern formed by a plurality of rectangles. Certainly, in other embodiments, the shape of the second electrode can also be any geometric shape, for example, a round shape, an arc shape, a serration shape, a regular polygon, an irregular polygon, a spiral shape or combinations thereof. Since the second electrode structure 3504 is, for example, an irregular polygon, spaces between various parts of the second electrode structure 3504 surrounding the edge area of the light-emitting device and various parts of the first electrode structure 3502 are not completely the same. Moreover, a connection line of any two points on the second electrode structure 3504 that has a longest distance may pass through the first electrode structure 3502.

In case that the external magnetic field is not applied, the current mainly gathered on a shorter path between the first electrode structure 3502 and the second electrode structure 3504, which may cause current distribution unevenness and influence the light-emitting efficiency. However, after applying the external magnetic field with the magnetic field direction 3512 to be a direction pointing out from the paper surface (shown in FIG. 42A), even if spaces between the first electrode structure 3502 and the second electrode structure 3504 are unfixed, the current 3520 is shifted along a clockwise direction under the function of the magnetic field, so that the current 3520 is evenly distributed to a region with a larger space from a region with a smaller space. Therefore, applying of the external magnetic field on the light-emitting device avails shifting the current 3520, so that the current 3520 can be evenly distributed in the region with a larger area, so as to improve the light-emitting efficiency.

Referring to FIG. 42B, in an embodiment, when the second electrode structure 3504' surrounds the first electrode structure 3502 in a symmetric manner, the external magnetic field can also be applied to improve the light-emitting efficiency. In detail, a connection line of any two points on the second electrode structure 3504' that has a longest distance may pass through the first electrode structure 3502, and the ring-shape second electrode structure 3504' shares a same center with the first electrode structure 3502. Although spaces between various parts of the first electrode structure 3502 and various parts of the second electrode structure 3504' are not completely the same, by adjusting the thickness of the TCL 3506 according to a magnetoresistance effect caused by the magnetic field, the impedance matching can be easily implemented, so as to improve the light-emitting efficiency of the light-emitting device.

In the embodiments of FIG. 42A and 42B, a situation that the second electrode structure entirely surrounds the first electrode structure disposed at the center region is taken as an example for descriptions, though the disclosure is not limited thereto. In other embodiments, a position of the first electrode structure can be deviated from the center region, and the second electrode of the second electrode structure is unnecessary to entirely surround the first electrode structure. Namely, the second electrode structure discontinuously surrounds the first electrode structure.

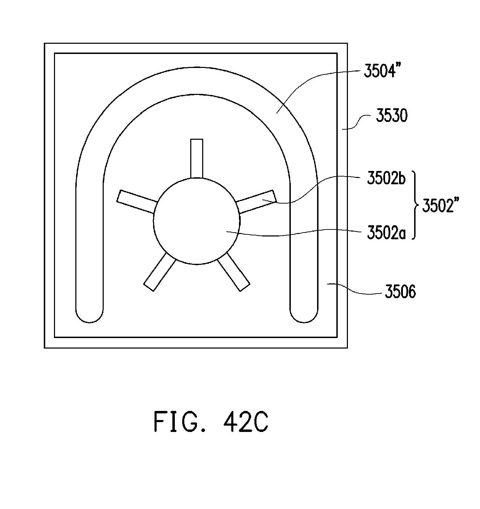

Referring to FIG. 42C, the first electrode structure 3502" is disposed at a position lower to the center. The first electrode structure 3502" includes a connection pad 3502a and a plurality of electrodes 3502b, the electrodes 3502b are connected to the connection pad 3502a. A shape of the electrode 3502b can be any geometric shape, for example, a round shape, an arc shape, a serration shape, a regular polygon, an irregular polygon, a spiral shape or combinations thereof. A second electrode of the second electrode structure 3504" is, for example, an arc shape having an opening facing downward, and surrounds a portion of the first electrode structure 3502".

It should be noticed that the second electrode that surrounds the first electrode structure may encircle an encircled region, and an area of the encircled region is at least 75% of the area of the top surface, and is preferably 75% of the area of the top surface.

Moreover, in the following embodiment, the TCL is configured in the light-emitting device, and the magnetoresistance effect is used to fine tune the respective thickness $t_t$ and $t_n$ of the TCL and the N-type doped layer, so as to easily implement the impedance matching between the TCL and the N-type doped layer, and implement a better current distribution and improve the light-emitting efficiency.

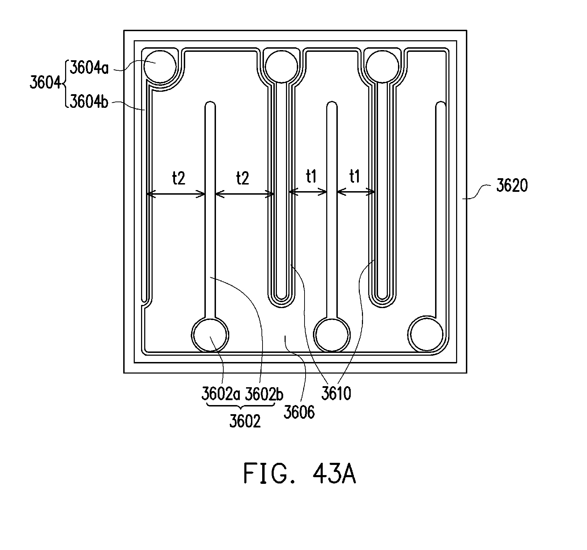

FIG. 43A to FIG. 43C are top views of a light-emitting device according to another embodiment of the disclosure. It should be noticed that for simplicity's sake, electrode distribution configurations are mainly illustrated in FIGs. 43A-43C, and configuration positions of other components can be implemented and varied according to the techniques known by those skilled in the art.

Referring to FIG. 43A, in the embodiment, the light-emitting device is a horizontal LED, which includes a light-emitting structure and a magnetic submount 3620. The magnetic submount 3620 is, for example, coupled to the light-emitting structure through epoxy, metal bonding, wafer bonding, epitaxy embedding or coating, etc. In another embodiment, the magnetic material can be coupled to the light-emitting structure through a package structure such as flip chip bond.

The light-emitting device having the magnetic field includes a plurality of first electrode structures 3602 and a plurality of second electrode structures 3604 configured at the same side. The first electrode structures 3602 are disposed on a TCL 3606, and the first electrode structures 3602 are electrically connected to a first doped layer (not shown). The first doped layer is, for example, a P-type doped layer. In an embodiment, the first electrode structure 3602 includes a connection pad 3602a and an electrode 3602b, where the electrode 3602b is connected to the connection pad 3602a. A shape of the electrode 3602b can be any geometric shape, for example, a round shape, an arc shape, a serration shape, a regular polygon, an irregular polygon, a spiral shape or combinations thereof. As shown in FIG. 43A, the electrode 3602b has, for example, a bar shape, and the electrode 3602b extends outwards from one side of the connection pad 3602a. The second electrode structures 3604 are disposed on a second doped layer 3610, and the second electrode structures 3604 are electrically connected to the second doped layer 3610. The second doped layer 3610 is, for example, an N-type doped layer. In an embodiment, the second electrode structure 3604 includes a connection pad 3604a and an electrode 3604b, where the electrode 3604b is connected to the connection pad 3604a. A shape of the electrode 3604b can be any geometric shape, for example, a round shape, an arc shape, a serration shape, a regular polygon, an irregular polygon, a spiral shape or combinations thereof. The electrode 3604b has, for example, a bar shape, and the electrode 3604b extends outwards from one side of the connection pad 3604a.

The first electrode structures 3602 and the second electrode structures 3604 are, for example, disposed in interlace, and the first electrode structures 3602 and the second electrode structures 3604 may have multiple electrode spaces. In detail, the electrodes 3602b of the first electrode structures 3602 and the electrodes 3604b of the second electrode structures 3604 are interlaced, the electrodes 3604b are disposed at two opposite sides of at least a part of the electrodes 3602b, and the electrodes 3602b are disposed at two opposite sides of at least a part of the electrodes 3604b. An outline of the electrode 3602b projected on a horizontal plane and an outline of the electrode 3604b projected on the horizontal plane are parallel to each other without intersection. A shortest projection space between the outline of the electrode 3602b of the first electrode structure 3602 and the outline of the electrode 3604b of the second electrode structure 3604 on the horizontal plane can be the same or different. In an embodiment, the first electrode structure 3602 and two adjacent second electrode structures 3604 thereof are regarded as one electrode set, and in each electrode set, the shortest projection spaces between the outline of the electrode 3602b of the first electrode structure 3602 and the outlines of the electrodes 3604b of two adjacent second electrode structures 3604 on the horizontal plane are the same. In different electrode sets, a shortest projection space t1 between the outline of the electrode 3602b of the first electrode structure 3602 and the outline of the electrode 3604b of the adjacent second electrode structure 3604 on the horizontal plane can be different to a shortest projection space t2 between the outline of the electrode 3602b of the first electrode structure 3602 and the outline of the electrode 3604b of the adjacent second electrode structure 3604 on the horizontal plane in another electrode set, i.e. the so-called multiple electrode spaces.

It should be noticed that the magnetic field is applied to the light-emitting device to achieve an overall equivalent impedance matching, and the shortest projection space t1 or the shortest projection space t2 between the outline of the electrode 3602b of the first electrode structure 3602 and the outline of the electrode 3604b of the adjacent second electrode structure 3604 on the horizontal plane is greater than 100 $\mu$m. Since the electrode material is generally non-transparent, in the light-emitting device of the embodiment, an electrode space can be increased to reduce the number of configured electrodes, so as to increase a light-emitting area.

Moreover, since the light-emitting device can implement the impedance matching through the magnetoresistance effect of the magnetic field, a size of the light-emitting device can be greater than 40 mils (1 mm $\times$ 1 mm). Moreover, in the large size light-emitting device, good light-emitting efficiency can be achieved by only taking the connection pad as the electrode structure without configuring the electrode, which avails reducing a configuration area of the electrode to improve the light-emitting area, and avails development of high power light-emitting devices.

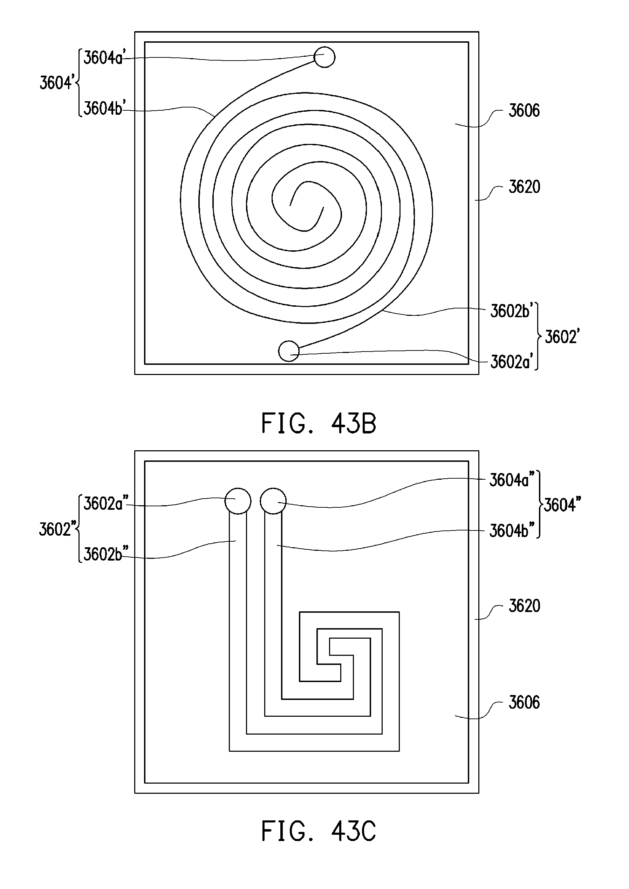

Moreover, the interlaced electrode layout can also be as that shown in FIG. 43B and FIG. 43C, where an outline of a first electrode of the first electrode structure and an outline of a second electrode of the second electrode structure on the horizontal plane are parallel. It should be noticed that mutual parallel of the outline of the first electrode and the outline of the second electrode refers to that the two outlines are never intersected, though it is not limited whether the outlines are straight lines or curves.

Referring to FIG. 43B, the first electrode structure 3602' includes a connection pad 3602' and an electrode 3602b', where the electrode 3602b' is connected to the connection pad 3602a'. The second electrode structure 3604' includes a connection pad 3604a' and an electrode 3604b', where the electrode 3604b' is connected to the connection pad 3604a'. In an embodiment, the electrode 3602b' of the first electrode structure 3602' and the electrode 3604b' of the second electrode structure 3604' all have a round spiral shape and are configured in interlace. An outline of the electrode 3602b' projected on the horizontal plane and an outline of the electrode 3604b' projected on the horizontal plane are, for example, parallel to each other.

Referring to FIG. 43C, the first electrode structure 3602" includes a connection pad 3602" and an electrode 3602b", where the electrode 3602b" is connected to the connection pad 3602a". The second electrode structure 3604" includes a connection pad 3604a" and an electrode 3604b", where the electrode 3604b" is connected to the connection pad 3604a". In an embodiment, the electrode 3602b" of the first electrode structure 3602" and the electrode 3604b" of the second electrode structure 3604" all have a square spiral shape and are configured in interlace. An outline of the electrode 3602b" projected on the horizontal plane and an outline of the electrode 3604b" projected on the horizontal plane are, for example, parallel to each other.

It should be noticed that besides the aforementioned embodiments, the disclosure further has other implementations. In the electrode layout configurations of the aforementioned embodiments, a plurality of layouts can be simultaneously used in a same chip, which can be adjusted according to an actual design requirement by those skilled in the art, and is not limited by the disclosure.

In conclusion, a light-emitting device of an embodiment of the disclosure includes a TCL, and in case that an external magnetic field is applied, the respective thickness of the TCL and the N-type doped layer can be easily adjusted to equalize the magnetoresistances of the TCL and the N-type doped layer. Since the magnetic field can be used to implement the impedance matching between the TCL and the N-type doped layer, a maximum even distribution area of the current in the light-emitting device can be obtained, so as to effectively improve the current evenness and the light-emitting efficiency of the light-emitting device.

Moreover, since the impedance matching of the light-emitting device can be implemented by applying the magnetic field, in the large-size light-emitting device, the problem of current distribution unevenness can be resolved even without configuring the electrode of the electrode structure.

According to the aforementioned consideration of the magnetoresistance parameters, it is assumed that the TCL has a resistivity $\rho_t$, a thickness $t_t$ and a carrier mobility $\mu_t$, and the N-type doped layer has a resistivity $\rho_n$, a thickness $t_n$ and a carrier mobility $\mu_n$. Magnitudes of the spaces t1 and t2 between the interlaced first electrodes and the second electrodes makes that an accumulated difference of the magnetoresistance parameters satisfies a following condition under the applied magnetic field:

$$\left| \frac{\dfrac{\rho_t}{t_t}(1 + \mu_t^2 B^2) - \dfrac{\rho_n}{t_n}(1 + \mu_n^2 B^2)}{\dfrac{\rho_t}{t_t}(1 + \mu_t^2 B^2) + \dfrac{\rho_n}{t_n}(1 + \mu_n^2 B^2)} \right| \le 0.2$$

It should be noticed that there are other implementations besides the aforementioned embodiments. In the electrode layout configurations of the aforementioned embodiments, a plurality of layouts can be simultaneously used in a same chip, which can be adjusted according to an actual design requirement by those skilled in the art, and is not limited by the disclosure.

In summary, spaces between various parts of the first electrode and various parts of the second electrode of the light-emitting device of the disclosure are not completely the same, and the magnetic field can be used to shift the current between the first electrode and the second electrode by the Lorenz's force, so that the current can be evenly distributed in a large area. Therefore, the current evenness and light-emitting efficiency of the light-emitting device can be effectively improved.

Moreover, the magnetoresistance effect caused by the magnetic field can be used to implement an overall equivalent impedance matching of the light-emitting device, which avails increasing the space between the finger portion of the first electrode and the finger portion of the second electrode, so as to reduce the number of the used electrodes and increase the light-emitting area.

It will be apparent to those skilled in the art that various modifications and variations can be made to the structure of the disclosure without departing from the scope or spirit of the disclosure. In view of the foregoing, it is intended that the disclosure cover modifications and variations of this disclosure provided they fall within the scope of the following claims and their equivalents.

**Claims**

1. A light-emitting device, comprising:

   a light-emitting structure, comprising:

   a P-type semiconductor layer;
   an N-type semiconductor layer, having a resistivity $\rho_n$, a thickness $t_n$ and a carrier mobility $\mu_n$;
   an active layer, disposed between the P-type semiconductor layer and the N-type semiconductor layer; and
   a transparent conductive layer, disposed on the P-type semiconductor layer, and having a resistivity $\rho_t$, a thickness $t_t$ and a carrier mobility $\mu_t$; and
   a magnetic material structure, coupled to the light-emitting structure, and generating a magnetic field B in the light-emitting structure,

   wherein a first magnetoresistance parameter $\dfrac{\rho_t}{t_t}(1 + \mu_t^2 B^2)$ of the transparent conductive layer is substantially equal to a second magnetoresistance parameter $\dfrac{\rho_n}{t_n}(1 + \mu_n^2 B^2)$ of the N-type semiconductor layer.

2. The light-emitting device as claimed in claim 1, wherein the first magnetoresistance parameter and the second magnetoresistance parameter are complied with:

$$\frac{\left| \dfrac{\rho_t}{t_t}(1+\mu_t^2 B^2) - \dfrac{\rho_n}{t_n}(1+\mu_n^2 B^2) \right|}{\left| \dfrac{\rho_t}{t_t}(1+\mu_t^2 B^2) + \dfrac{\rho_n}{t_n}(1+\mu_n^2 B^2) \right|} \leq 0.2$$

3. The light-emitting device as claimed in claim 1, wherein the transparent conductive layer comprises metal or semiconductor.

4. The light-emitting device as claimed in claim 3, wherein the transparent conductive layer is a nickel-gold alloy, and a thickness thereof is between 50 and 150 Å.

5. The light-emitting device as claimed in claim 3, wherein the transparent conductive layer is an indium tin oxide, and a thickness thereof is between 1000 and 5000 Å.

6. The light-emitting device as claimed in claim 1, wherein the magnetic field B is at least 0.01 gauss.

7. The light-emitting device as claimed in claim 1, wherein the N-type semiconductor layer is N-type doped gallium nitride.

8. The light-emitting device as claimed in claim 1, wherein the light-emitting structure further comprises:

   a first electrode, coupled to the P-type semiconductor layer; and
   a second electrode, coupled to the N-type semiconductor layer.

9. A light-emitting device, comprising:

   a light-emitting structure, having a top surface, and comprising:

      a first type semiconductor layer;
      a second type semiconductor layer;
      an active layer, disposed between the first type semiconductor layer and the second type semiconductor layer;
      a transparent conductive layer, disposed on the first type semiconductor layer;
      a first electrode structure, disposed on the transparent conductive layer and coupled to the first type semiconductor layer, and comprising a first connection pad and a first electrode; and
      a second electrode structure, coupled to the second type semiconductor layer; and
      a magnetic material structure, coupled to the light-emitting structure, and generating a magnetic field B in the light-emitting structure,
      wherein the first electrode structure and the second electrode structure are located at a same side of the light-emitting structure.

10. The light-emitting device as claimed in claim 9, wherein the first electrode comprises a linear structure.

11. The light-emitting device as claimed in claim 9, wherein the first electrode has at least one symmetric centerline, and a structural portion of the first electrode corresponding to the symmetric centerline has a symmetric structure extending towards two sides.

12. The light-emitting device as claimed in claim 11, wherein the at least one symmetric centerline substantially bisects an area of the top surface, equally.

13. The light-emitting device as claimed in claim 12, wherein the at least one symmetric centerline passes through a second connection pad of the second electrode structure.

14. The light-emitting device as claimed in claim 9, wherein the first electrode does not have the symmetric centerline.

**15.** The light-emitting device as claimed in claim 9, wherein the magnetic field B is higher than 0.01 gauss.

**16.** The light-emitting device as claimed in claim 9, wherein the first electrode surrounds the second electrode structure.

**17.** The light-emitting device as claimed in claim 16, wherein a connection line of two points on the first electrode that has a longest distance passes through the second electrode structure.

**18.** The light-emitting device as claimed in claim 17, wherein the second electrode structure is a second electrode.

**19.** The light-emitting device as claimed in claim 17, wherein the second electrode structure is a second connection pad.

**20.** The light-emitting device as claimed in claim 16, wherein the magnetic field B is higher than 0.01 gauss.

**21.** A light-emitting device, comprising:

    a light-emitting structure, having a top surface, and comprising:

        a first type semiconductor layer;
        a second type semiconductor layer;
        an active layer, disposed between the first type semiconductor layer and the second type semiconductor layer;
        a transparent conductive layer, disposed on the first type semiconductor layer;
        a first electrode structure, coupled to the first type semiconductor layer, and comprising a first electrode and a first connection pad, wherein the first electrode has a first set of parallel outlines; ;and
        a second electrode structure, coupled to the second type semiconductor layer, and comprising a second electrode and a second connection pad, wherein the second electrode has a second set of parallel outlines; and
        a magnetic material structure, coupled to the light-emitting structure, and generating a magnetic field B in the light-emitting structure,
        wherein the first electrode and the second electrode are disposed in interlace, and the first set of parallel outlines and the second set of parallel outlines are disposed in parallel.

**22.** The light-emitting device as claimed in claim 21, wherein the magnetic field B is higher than 0.01 gauss.

**23.** The light-emitting device as claimed in claim 21, wherein shortest distances between two adjacent first sets of parallel outlines and the second set of parallel outlines are substantially identical.

**24.** The light-emitting device as claimed in claim 21, wherein shortest distances between two adjacent first sets of parallel outlines and the second set of parallel outlines are substantially different.

**25.** The light-emitting device as claimed in claim 21, wherein a shortest distance between two adj acent first sets of parallel outlines and the second set of parallel outlines is higher than 100 $\mu$m.

**26.** A light-emitting device, comprising:

    a light-emitting structure, comprising:

        a first type semiconductor layer;
        a second type semiconductor layer;
        an active layer, disposed between the first type semiconductor layer and the second type semiconductor layer;
        a transparent conductive layer, covering the second type semiconductor layer, wherein the first type semiconductor layer, the second type semiconductor layer or the transparent conductive layer comprises a weak magnetic material; and

    at least one magnetic field generator, located to at least one side of the light-emitting device, and generating a magnetic field B.

27. The light-emitting device as claimed in claim 26, wherein the at least one magnetic field generator refers to two magnetic field generators located at two opposite sides of the light-emitting device.

28. The light-emitting device as claimed in claim 26, wherein the magnetic field B is higher than 0.01 gauss.

29. A nitride semiconductor template, comprising:

> a submount;
> a bonding layer, disposed on the submount; and
> a nitride semiconductor layer, disposed on the bonding layer, wherein the nitride semiconductor layer comprises a weak magnetic material.

30. A light-emitting device package structure, comprising:

> a carrier;
> at least one light-emitting device, disposed on the carrier; and
> a first magnetic element, independent to the light-emitting device, and providing a magnetic field to the light-emitting device.

31. The light-emitting device package structure as claimed in claim 30, wherein the first magnetic element is a ring-shape structure, at least a block-like structure or at least a bar-shape structure.

32. The light-emitting device package structure as claimed in claim 31, wherein when the first magnetic element is a ring-shape structure, the light-emitting device is located in an opening of the ring-shape structure, and when the first magnetic element is a plurality of block-like structure, the block-like structures surround the light-emitting device, and when the first magnetic element is a plurality of bar-shape structures, the bar-shape structures surround the light-emitting device.

33. The light-emitting device package structure as claimed in claim 30, wherein the first magnetic element and the light-emitting device are all disposed on a surface of the carrier, and the light-emitting device package structure further comprises:

> an optical film layer, covering the first magnetic element.

34. The light-emitting device package structure as claimed in claim 30, further comprising:

> a second magnetic element, disposed on the carrier together with the first magnetic element, and a minimum space between the light-emitting device and the second magnetic element being less than a minimum space between the light-emitting device and the first magnetic element, wherein a side surface of the second magnetic element that faces to the light-emitting device is vertical or inclined.

35. The light-emitting device package structure as claimed in claim 30, wherein the carrier has a groove, and the light-emitting device is disposed in the groove.

36. The light-emitting device package structure as claimed in claim 35, wherein the first magnetic element is disposed on the carrier and located in the groove, and the first magnetic element is disposed at peripheral of the light-emitting device and a space is maintained between the first magnetic element and an inner wall of the groove.

37. The light-emitting device package structure as claimed in claim 36, further comprising:

> a second magnetic element, disposed on a sidewall of the carrier, wherein a side surface of the second magnetic element that faces to the light-emitting device is vertical or inclined.

38. The light-emitting device package structure as claimed in claim 37, further comprising:

> a third magnetic element, disposed on the carrier and located in the groove, and the third magnetic element is adhered to the inner wall of the groove, wherein a side surface of the third magnetic element that faces to the light-emitting device is vertical or inclined.

**39.** The light-emitting device package structure as claimed in claim 36, further comprising:

a second magnetic element, disposed on the carrier and located in the groove, wherein the second magnetic element is adhered to the inner wall of the groove.

**40.** The light-emitting device package structure as claimed in claim 35, wherein the first magnetic element is disposed on the carrier and located in the groove, and the first magnetic element is adhered to the inner wall of the groove.

**41.** The light-emitting device package structure as claimed in claim 35, wherein the first magnetic element is disposed on a sidewall of the carrier.

**42.** The light-emitting device package structure as claimed in claim 30, wherein the carrier is a lead frame, and the lead frame comprises:

a first pin and a second pin independent to each other, the light-emitting device is disposed on the first pin and is electrically connected to the second pin, and the magnetic element is disposed on the first pin or the second pin.

**43.** The light-emitting device package structure as claimed in claim 30, wherein the carrier comprises a substrate, a casing, a first pin and a second pin, the casing covers a part of the substrate, a part of the first pin and a part of the second pin, and separates the substrate, the first pin and the second pin, and the light-emitting device is disposed on a part of the substrate that is not covered by the casing.

**44.** The light-emitting device package structure as claimed in claim 43, wherein the substrate serves as a thermal conductive device.

**45.** The light-emitting device package structure as claimed in claim 44, wherein a material of the substrate is metal.

**46.** The light-emitting device package structure as claimed in claim 43, wherein the substrate has a groove, and the light-emitting device is disposed in the groove.

**47.** The light-emitting device package structure as claimed in claim 46, wherein the first magnetic element is disposed on a sidewall of the substrate.

**48.** The light-emitting device package structure as claimed in claim 46, wherein the first magnetic element is disposed in the groove, and the first magnetic element is adhered to an inner wall of the groove.

**49.** The light-emitting device package structure as claimed in claim 46, wherein the first magnetic element is disposed in the groove, and a space is maintained between the first magnetic element and an inner wall of the groove.

**50.** The light-emitting device package structure as claimed in claim 49, further comprising:

a second magnetic element, disposed in the groove, wherein the second magnetic element is adhered to an inner wall of the groove.

**51.** The light-emitting device package structure as claimed in claim 50, further comprising:

a third magnetic element, disposed on a sidewall of the substrate.

**52.** The light-emitting device package structure as claimed in claim 49, further comprising:

a second magnetic element, disposed on a sidewall of the substrate.

**53.** The light-emitting device package structure as claimed in claim 43, wherein the light-emitting device is disposed on a first surface of the substrate, and the first magnetic element is disposed on a second surface of the substrate opposite to the first surface.

**54.** The light-emitting device package structure as claimed in claim 43, wherein a part of the first magnetic element is embedded in the substrate.

**55.** The light-emitting device package structure as claimed in claim 43, further comprising:

a second magnetic element, disposed on the first pin or the second pin.

**56.** The light-emitting device package structure as claimed in claim 43, wherein the first magnetic element is disposed on the first pin or the second pin.

**57.** The light-emitting device package structure as claimed in claim 30, wherein when the first magnetic element and the light-emitting device are all disposed on a surface of the carrier, the first magnetic element has a slant facing to the top of the light-emitting device, and an included angle between a normal vector of the slant and a normal vector of the surface is less than 90 degrees.

**58.** The light-emitting device package structure as claimed in claim 30, wherein a minimum space between the first magnetic element and the light-emitting device is below 5 cm.

**59.** The light-emitting device package structure as claimed in claim 30, wherein a minimum space between the first magnetic element and the light-emitting device is below 3 cm.

FIG. 1 (RELATED ART)

FIG. 2 (RELATED ART)

Light

300

310

332

330

350

360

340

320

FIG. 3

FIG. 4

FIG. 5

EP 2 453 486 A2

2202

2204

2206

2210

2208

2212

2220

2200

FIG. 6

2320

2304

2302

2202

2204

2206

2210

2208

2212

2300

FIG. 7

FIG. 8

FIG. 9

FIG. 10

FIG. 11

FIG. 12

2402

$t_t$

$t_n$

2430

2404

2406

2408

2410

2420

2400a

FIG. 13

600

632    620    640
       630    612
             610
D

FIG. 14A

620    630

I         I'

FIG. 14B

FIG. 14C

FIG. 14D

FIG. 14E

620   630

FIG. 14F

630   620

FIG. 14G

630a ⎱ 630
630a ⎰
620

FIG. 14H

FIG. 14I

FIG. 14J

FIG. 14K

FIG. 14L

FIG. 14M

700

730

722

710

620

720

722a

740

722

W2

W1

FIG. 15A

700a

620

720

630

D2

D1

FIG. 15B

FIG. 15C

FIG. 16A

FIG. 16B

FIG. 16C

FIG. 16D

FIG. 17A

FIG. 17B

FIG. 17C

FIG. 17D

FIG. 17E

FIG. 18A

FIG. 18B

1000b

1012a

1020

1012b    1030b    1012

1016

1018

FIG. 18C

1000c

1020

1030c

1030c

1016

1018

1012

FIG. 18D

FIG. 18E

FIG. 19A

FIG. 19B

FIG. 19C

FIG. 20A

FIG. 20B

FIG. 20C

FIG. 20D

FIG. 21

FIG. 22

FIG. 23

FIG. 24

FIG. 25

FIG. 26

FIG. 27

FIG. 28

FIG. 29

FIG. 30

FIG. 31

4112

4120

4110
4108
4106
4104b ⎱
⎰ 4104
4104a
4114
4130

FIG. 32

4130

4120

4100

4102

4114

4104b ⎱
⎰ 4104
4104a

4106
4108

4110

4112

4170          4170          4160

FIG. 33

FIG. 34A

FIG. 34B

EP 2 453 486 A2

FIG. 35A

FIG. 35B

4108

4106

4104

4102

4100

FIG. 36A

4110a ⎫
4110b ⎬ 4110
⎭

4108

4106

4104

4102

4100

FIG. 36B

4112

4114

4110a ⎫
4110b ⎬ 4110
⎭

4108

4106

4104

4102

4100

4130

FIG. 36C

FIG. 37A

FIG. 37B

4112

4110a

4114

4110b

4108

4106

4104

4102

4100

4130

FIG. 37C

FIG. 38A

FIG. 38B

FIG. 38C

4100

4102a

4204 → 4102b

4104b } 4104
4104a

4202b } 4202
4202a

4200

## FIG. 38D

4100

4102a

4102b

4104

4202b } 4202
4202a

4200

## FIG. 38E

EP 2 453 486 A2

FIG. 38F

FIG. 38G

71

FIG. 39

FIG. 40A

FIG. 40B

FIG. 40C

FIG. 41A

FIG. 41B

FIG. 41C

FIG. 42A

FIG. 42B

3504"
3530
3502b
3502"
3502a
3506

FIG. 42C

FIG. 43A

FIG. 43B

FIG. 43C